# EUROPEAN PATENT APPLICATION

(11) **EP 4 804 761 A1**
(43) Date of publication of application: **09.09.2026**
(21) Application number: 24885955.5
(22) Date of filing: 16.07.2024
(51) Int. Cl.: H10D 64/66, H10D 30/67, H10K 59/121, H10K 59/131, H10K 59/82, H10K 59/80, H10K 102/10

(54) **DISPLAY DEVICE**

(30) Priority: 30.10.2023 KR 20230146643
(71) Applicant: Samsung Display Co., Ltd., Yongin-si, Gyeonggi-do 17113 (KR)
(72) Inventor: PARK, Joon Yong, Yongin-si, Gyeonggi-do 17113 (KR); JEONG, Sam Tae, Yongin-si, Gyeonggi-do 17113 (KR); CHUNG, Yung Bin, Yongin-si, Gyeonggi-do 17113 (KR)
(74) Representative: Dr. Weitzel & Partner
(86) International application number: PCT/KR2024/010167
(87) International publication number: WO 2025/095275

(57) **Abstract**

A display device is provided. The display device comprises: a substrate; a first conductive layer disposed on the substrate; an active layer disposed on the first conductive layer; a second conductive layer disposed on the active layer, including a transparent conductive oxide (TCO), and not including indium (In); a third conductive layer disposed on the second conductive layer; a transistor comprising a gate electrode disposed in the second conductive layer, and a drain electrode and a source electrode which are disposed in the active layer; and a light-emitting element including a first electrode and disposed in the third conductive layer and connected to the source electrode.

## Description

### [Technical Field]

The present invention relates to a display device.

### [Background Art]

Display devices are becoming increasingly important with the development of multimedia. Accordingly, various display devices such as liquid crystal display devices (LCDs) and organic light emitting diode display devices (OLEDs) are being developed.

Of the display devices, a self-light emitting display device includes a self-light emitting element such as an organic light emitting diode. The self-light emitting element may include two electrodes facing each other and a light emitting layer interposed between the two electrodes. When the self-light emitting element is an organic light emitting diode, electrons and holes provided from the two electrodes may be recombined in the light emitting layer to generate excitons. As the generated excitons change from an excited state to a ground state, light may be emitted.

Since self-light emitting display devices do not need a light source such as a backlight unit, they are low in power consumption, can be made lightweight and thin, and have a wide viewing angle, high luminance and contrast, and fast response speed. Due to these high-quality characteristics, the self-light emitting display devices are drawing attention as next-generation display devices.

A self-light emitting display device may include various circuit layers for driving a light emitting layer. These circuit layers may be formed through a plurality of patterning processes using masks. As the number of masks and the number of layers constituting a circuit layer decreases, process efficiency can be improved. Accordingly, a height difference between the light emitting layer and a transistor for driving the light emitting layer can be reduced.

### [Detailed Description of the Invention]

### [Technical Problem]

An object to be solved by the present invention is to provide a display device including a conductive layer with low reflectivity.

Another object to be solved by the present invention is to provide a display device with reduced or minimized light-induced degradation.

Still another object to be solved by the present invention is to provide a display device with improved reliability.

Still another object to be solved by the present invention is to provide a display device with improved process efficiency.

The objects of the present invention are not limited to the objects mentioned above, and other technical objects not mentioned will be clearly understood by a person skilled in the art from the following description.

### [Technical Solution]

A display device according to an embodiment for solving the above-described objects includes, a substrate, a first conductive layer disposed on the substrate, an active layer disposed on the first conductive layer, a second conductive layer disposed on the active layer, a third conductive layer disposed on the second conductive layer, a transistor including a gate electrode disposed in the second conductive layer and a drain electrode and a source electrode disposed in the active layer, and a light emitting element including a first electrode disposed in the third conductive layer and connected to the source electrode, wherein the second conductive layer includes transparent conductive oxide (TCO) and does not include indium (In).

The second conductive layer may include aluminum-zinc-tin-oxide (AZTO).

The second conductive layer may include a first gate conductive layer and a second gate conductive layer disposed on the first gate conductive layer, and the second gate conductive layer may have higher light transmittance than the first gate conductive layer.

The second gate conductive layer may include aluminum-zinc-tin-oxide (AZTO).

The second gate conductive layer may include 1 to 10 at% of aluminum based on atoms excluding oxygen atoms.

The second gate conductive layer may include 60 to 90 at% of zinc based on the atoms excluding the oxygen atoms.

The second gate conductive layer may include 10 to 30 at% of tin based on the atoms excluding the oxygen atoms.

The second gate conductive layer may include 0.5 to 5 at% of aluminum based on total atoms.

The second gate conductive layer may include 20 to 40 at% of zinc based on the total atoms.

The second gate conductive layer may include 7 to 15 at% of tin based on the total atoms.

The second gate conductive layer may include 50 to 60 at% of oxygen based on the total atoms.

The first gate conductive layer may have lower reflectivity than the second gate conductive layer.

The first gate conductive layer may include titanium (Ti).

A thickness of the second gate conductive layer may be greater than a thickness of the first gate conductive layer.

The thickness of the second gate conductive layer may be 2 to 30 times the thickness of the first gate conductive layer.

The thickness of the second gate conductive layer may be 400 to 3000 Å.

The thickness of the first gate conductive layer may be 100 to 200 Å.

The third conductive layer may include transparent conductive oxide (TCO), and the transparent conductive oxide (TCO) of the second conductive layer and the transparent conductive oxide (TCO) of the third conductive layer may be different materials.

The second conductive layer may have lower reflectivity than at least any one of the first conductive layer and the third conductive layer.

A display device according to another embodiment for solving the above-described objects includes a substrate, a first conductive layer disposed on the substrate, an active layer disposed on the first conductive layer, a second conductive layer disposed on the active layer, a transistor disposed on the first conductive layer, and a light emitting element disposed on the second conductive layer and connected to the transistor, wherein the second conductive layer includes, a first gate conductive layer including a first material, a second gate conductive layer disposed on the first gate conductive layer and including a second material, a third gate conductive layer disposed on the second gate conductive layer and including a third material, and a fourth gate conductive layer disposed on the third gate conductive layer and including aluminum-zinc-tin-oxide (AZTO), wherein the first through third materials include metal.

The first through third materials may include molybdenum (Mo), aluminum (Al), chromium (Cr), gold (Au), titanium (Ti), nickel (Ni), neodymium (Nd), copper (Cu), or an alloy thereof.

The first material may include titanium (Ti).

The second material may include copper (Cu).

The third material may include titanium (Ti).

A thickness of the fourth gate conductive layer may be greater than a thickness of the third gate conductive layer.

A thickness of the second gate conductive layer may be greater than the thickness of the fourth gate conductive layer.

A display device according to still another embodiment for solving the above-described objects includes a substrate including a display area and a pad area disposed on a side of the display area, a first conductive layer disposed on the substrate, an active layer disposed on the first conductive layer, a second conductive layer disposed on the active layer, a transistor disposed on the first conductive layer in the display area, a light emitting element disposed on the second conductive layer in the display area and connected to the transistor, and a wiring pad disposed on the substrate in the pad area, wherein the wiring pad includes a first pad electrode disposed in the first conductive layer and a second pad electrode disposed in the second conductive layer, and the second conductive layer disposed in the display area includes transparent conductive oxide and does not include indium (In).

The second pad electrode may not include transparent conductive oxide.

The display device may further include a driving component connected to the wiring pad, the second pad electrode may include a sub-pad layer directly contacting the driving component, and the sub-pad layer may include metal.

### [Effects of the Invention]

According to one or more embodiments of the present invention, a display device may include a conductive layer with low reflectivity.

According to one or more embodiments of the present invention, a display device may reduce or minimize light-induced degradation.

According to one or more embodiments of the present invention, reliability of a display device may be improved.

According to one or more embodiments of the present invention, process efficiency of a display device may be improved.

The effects according to the embodiments are not limited to those illustrated above, and various other effects are included in the present specification.

### [Brief Description of the Drawings]

FIG. 1 is a perspective view of a display device according to an embodiment.
FIG. 2 is a cross-sectional view taken along line X1-X1' of FIG. 1.
FIG. 3 is a cross-sectional view of a display device according to an embodiment.
FIG. 4 is a plan view illustrating a state in which flexible films are attached to wiring pads of the display device according to the embodiment.
FIG. 5 is a plan view illustrating a state in which the flexible films are not attached to the wiring pads of the display device according to the embodiment.
FIG. 6 illustrates pixels and lines of the display device according to the embodiment.
FIG. 7 is a schematic plan view of a part of a display area of a display substrate according to an embodiment.
FIG. 8 is a schematic plan view of a part of a display area of a display substrate according to an embodiment.
FIG. 9 is a cross-sectional view taken along line X2-X2 of FIG. 8.
FIG. 10 is an equivalent circuit diagram of a pixel according to an embodiment.
FIG. 11 is a cross-sectional view of an example of a first transistor of a circuit layer according to an embodiment.
FIG. 12 is a cross-sectional view of an example of a second transistor and a third transistor of the circuit layer according to the embodiment.
FIG. 13 is a cross-sectional view illustrating an example of a part of a display area and a part of a pad area of the display device according to the embodiment.
FIG. 14 is a cross-sectional view of an example of a bottom conductive layer according to an embodiment.
FIG. 15 is a cross-sectional view of an example of a gate conductive layer according to an embodiment.
FIG. 16 is a cross-sectional view of an example of an anode conductive layer according to an embodiment.
FIG. 17 is a cross-sectional view of an example of a conventional gate conductive layer.
FIG. 18 is a photograph showing a precipitated particle formed on a cross section of the conventional gate conductive layer.
FIG. 19 is a cross-sectional view illustrating an example of a part of a display area and a part of a pad area of a display device according to an embodiment.
FIG. 20 is a cross-sectional view illustrating a wiring pad and a flexible film of the display device according to the embodiment.
FIGS. 21 through 23 are schematic perspective views of devices including a display device according to an embodiment.
FIGS. 24 and 25 are schematic perspective views of a transparent display device including a display device according to an embodiment.

### [Mode for Invention]

The advantages and features of the present invention, and methods of achieving the same, will become apparent with reference to the embodiments described in detail below in conjunction with the accompanying drawings. However, the present invention is not limited to the embodiments disclosed below and may be implemented in various different forms. The embodiments are provided only to make the disclosure of the present invention complete and to fully inform a person having ordinary skill in the art to which the present invention pertains of the scope of the invention, and the present invention is defined only by the scope of the claims.

When an element or layer is referred to as being "on" another element or layer, it includes both a case where the element or layer is directly on the other element or layer and a case where another layer or another element is interposed therebetween. Similarly, references to "below," "left," and "right" include both cases where elements are directly adjacent to each other and cases where another layer or another material is interposed therebetween. Throughout the specification, the same reference numerals refer to the same components.

Hereinafter, specific embodiments will be described with reference to the accompanying drawings.

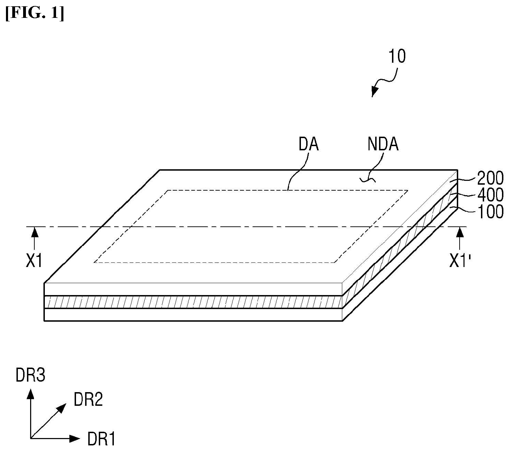

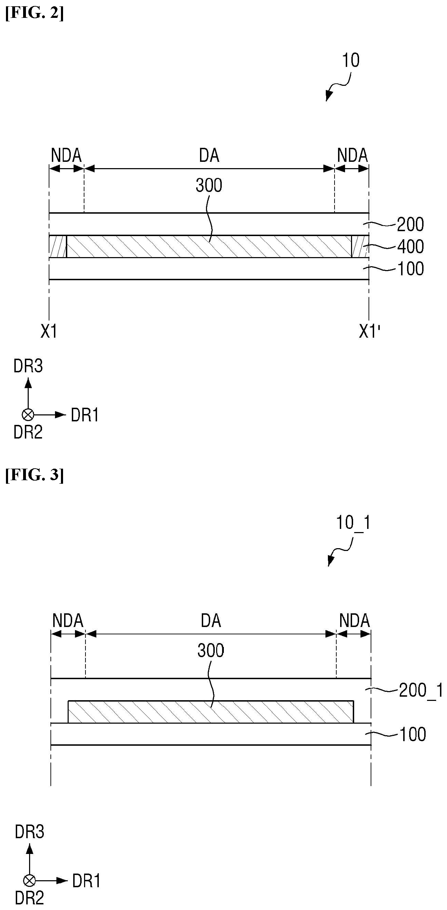

FIG. 1 is a perspective view of a display device 10 according to an embodiment. FIG. 2 is a cross-sectional view taken along line X1-X1' of FIG. 1. FIG. 3 is a cross-sectional view of a display device 10_1 according to an embodiment.

Referring to FIGS. 1 through 3, the display device 10 may be applied to various electronic devices including small and medium-sized electronic equipment such as tablet personal computers (PCs), smartphones, car navigation units, cameras, center information displays (CIDs) provided in vehicles, wristwatch type electronic devices, personal digital assistants (PDAs), portable multimedia players (PMPs) and game consoles and medium and large-sized electronic equipment such as televisions, outdoor billboards, monitors, PCs and notebook computers. These are merely presented as examples, and the display device 10 may also be employed in other electronic devices as long as not departing from the spirit of the present invention.

In an embodiment, the display device 10 may be rectangular in plan view. The display device 10 may include two long sides extending in a first direction DR1 and two short sides extending in a second direction DR2 crossing the first direction DR1. Each corner where a long side of the display device 10 meets a short side may be right-angled, but is not limited thereto, and each corner may also form a curved surface. In an embodiment, the long sides may extend in the second direction DR2, and the short sides may extend in the first direction DR1. The planar shape of the display device 10 is not limited to the above example and may also be a circular shape or other shapes.

In the drawings, the first direction DR1 and the second direction DR2 are horizontal directions crossing each other. For example, the first direction DR1 and the second direction DR2 may be orthogonal to each other. In addition, a third direction DR3 may cross the first direction DR1 and the second direction DR2, for example, may be a vertical direction orthogonal to the first direction DR1 and the second direction DR2. Unless otherwise defined, in the present specification, a direction indicated by an arrow of each of the first through third directions DR1 through DR3 may be referred to as one side, and the opposite direction may be referred to as the other side. In addition, in the present specification, "on", "upper side", "above", "top", and "upper surface" refer to a direction in which the arrow of the third direction DR3 points in the drawings, and "under", "lower side", "below", "bottom", and "lower surface" refer to a direction opposite to the direction in which the arrow of the third direction DR3 points in the drawings.

The display device 10 may include a display area DA displaying an image and a non-display area NDA not displaying an image. In an embodiment, the non-display area NDA may be located around the display area DA and may surround the display area DA.

In an embodiment, as illustrated in FIG. 2, the display device 10 may include a display substrate 100 and a color conversion substrate 200 facing the display substrate 100 and may further include a sealing part 400 bonding the display substrate 100 and the color conversion substrate 200 together and a filler 300 filling a space between the display substrate 100 and the color conversion substrate 200.

The display substrate 100 may include elements and circuits for displaying an image, for example, pixel circuits such as switching elements, a pixel defining layer defining emission areas and a non-emission area, which will be described later, in the display area DA, and self-light emitting elements. In an embodiment, each of the self-light emitting elements may include at least one of an organic light emitting diode, a quantum dot light emitting diode, an inorganic material-based micro light emitting diode (e.g., micro LED), and an inorganic material-based nano light emitting diode (e.g., nano LED). For ease of description, a case where the self-light emitting elements are organic light emitting diodes will be described below as an example.

The color conversion substrate 200 may be located on the display substrate 100 and may face the display substrate 100. In an embodiment, the color conversion substrate 200 may include a color conversion pattern that converts the color of incident light. In an embodiment, the color conversion pattern may include at least any one of a color filter and a wavelength conversion pattern.

The sealing part 400 may be located between the display substrate 100 and the color conversion substrate 200 in the non-display area NDA. The sealing part 400 may be disposed along edges of the display substrate 100 and the color conversion substrate 200 in the non-display area NDA to surround the display area DA in plan view. The display substrate 100 and the color conversion substrate 200 may be bonded to each other by the sealing part 400.

In an embodiment, the sealing part 400 may be made of an organic material. For example, the sealing part 400 may be made of, but not limited to, epoxy-based resin.

The filler 300 may be located in the space surrounded by the sealing part 400 between the display substrate 100 and the color conversion substrate 200. The filler 300 may fill the space between the display substrate 100 and the color conversion substrate 200.

In an embodiment, the filler 300 may be made of a material that can transmit light. In an embodiment, the filler 300 may be made of an organic material. For example, the filler 300 may be made of, but not limited to, a silicon-based organic material or an epoxy-based organic material. In an embodiment, the filler 300 may also be omitted.

In an embodiment, as illustrated in FIG. 3, the display device 10_1 may not include the sealing part 400. For example, a color conversion substrate 200_1 of the display device 10_1 may be an encapsulation substrate. The color conversion substrate 200_1 may include a protruding portion disposed along the periphery of the color conversion substrate 200_1 and protruding toward a display substrate 100 in the third direction DR3 and a recessed portion surrounded by the protruding portion. The internal space may be sealed by the display substrate 100, the color conversion substrate 200_1, and the protruding portion. A filler 300 may fill the recessed portion.

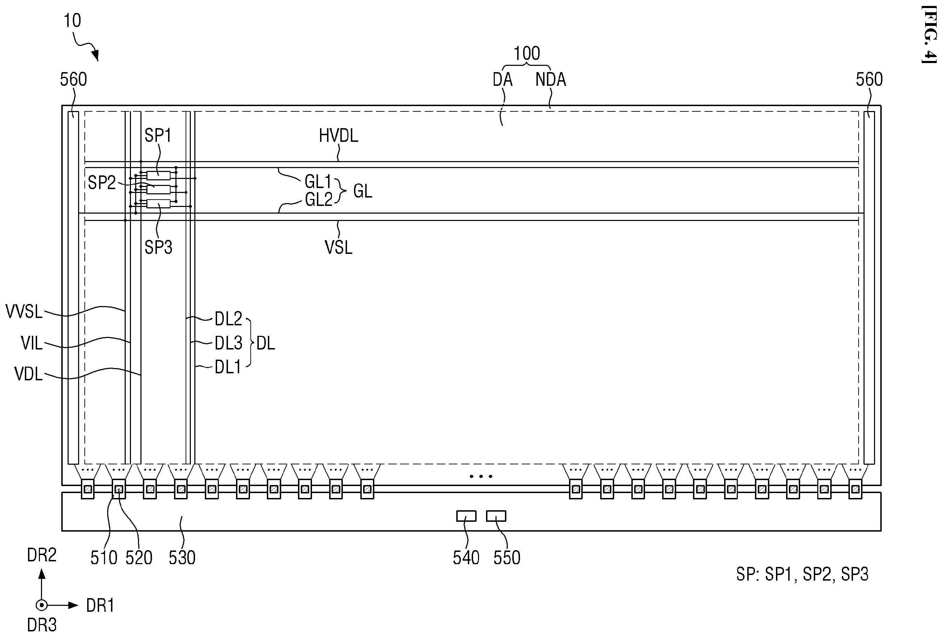

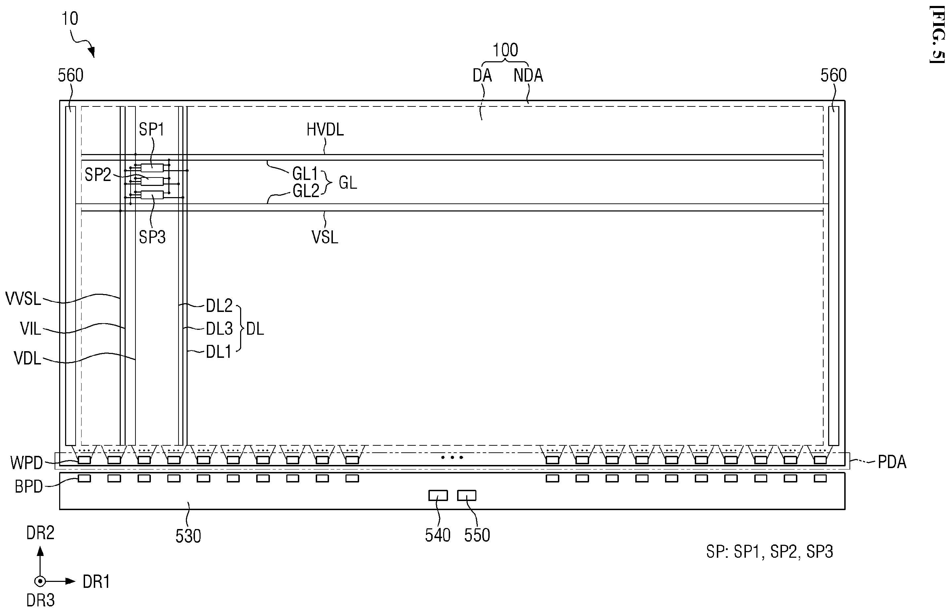

FIG. 4 is a plan view illustrating a state in which flexible films are attached to wiring pads of the display device according to the embodiment. FIG. 5 is a plan view illustrating a state in which the flexible films are not attached to the wiring pads of the display device according to the embodiment.

Referring to FIGS. 4 and 5, the display device 10 may include the display substrate 100, the connection films 510, display drivers 520, a circuit board 530, a timing controller 540, a power supply 550, and gate drivers 560.

The display substrate 100 may be rectangular in plan view. For example, the display substrate 100 may be shaped like a rectangular plane having long sides in the first direction DR1 and short sides in the second direction DR2. Each corner where a long side extending in the first direction DR1 meets a short side extending in the second direction DR2 may be right-angled or may be rounded with a predetermined curvature. The planar shape of the display substrate 100 is not limited to a rectangular shape and may also be other polygonal shapes, a circular shape, or an oval shape. For example, the display substrate 100 may be formed flat, but is not limited thereto. For another example, the display substrate 100 may be formed to be bent with a predetermined curvature.

The display substrate 100 may include a display area DA and a non-display area NDA.

The display area DA may be an area for displaying an image and may be defined as a central area of the display substrate 100. In an embodiment, the display area DA may include pixels SP, gate lines GL, data lines DL, initialization voltage lines VIL, first voltage lines VDL, horizontal voltage lines HVDL, vertical voltage lines VVSL, and second voltage lines VSL.

The pixels SP may be respectively formed in pixel areas intersected by the data lines DL and the gate lines GL. In an embodiment, the pixels SP may include first through third pixels SP1 through SP3. Each of the first through third pixels SP1 through SP3 may be connected to a gate line GL and a data line DL. Each of the first through third pixels SP1 through SP3 may be defined as a minimum unit area that outputs light.

Each of the first through third pixels SP1 through SP3 may include an organic light emitting diode including an organic light emitting layer, a quantum dot light emitting diode including a quantum dot light emitting layer, a micro light emitting diode, or an inorganic light emitting diode including an inorganic semiconductor.

The first pixels SP1 may emit light of a first color or red light, the second pixels SP2 may emit light of a second color or green light, and the third pixels SP3 may emit light of a third color or blue light. Pixel circuits of the first pixels SP1, pixel circuits of the second pixels SP2, and pixel circuits of the third pixels SP3 may be sequentially arranged in a direction opposite to the second direction DR2, but the order of the pixel circuits is not limited thereto.

The gate lines GL may include first gate lines GL1 and second gate lines GL2. The first gate lines GL1 may extend in the first direction DR1 and may be spaced apart from each other in the second direction DR2. The first gate lines GL1 may receive first gate signals from the gate drivers 560 and supply the first gate signals to the first through third pixels SP1 through SP3.

The second gate lines GL2 may extend in the first direction DR1 and may be spaced apart from each other in the second direction DR2. The second gate lines GL2 may receive second gate signals from the gate drivers 560 and supply the second gate signals to the first through third pixels SP1 through SP3.

The data lines DL may extend in the second direction DR2 and may be spaced apart from each other in the first direction DR1. The data lines DL may include first through third data lines DL1 through DL3. The first through third data lines DL1 through DL3 may supply data voltages to the first through third pixels SP1 through SP3, respectively.

The initialization voltage lines VIL may extend in the second direction DR2 and may be spaced apart from each other in the first direction DR1. The initialization voltage lines VIL may supply initialization voltages received from the display drivers 520 to the pixel circuits of the first through third pixels SP1 through SP3. The initialization voltage lines VIL may receive sensing signals from the pixel circuits of the first through third pixels SP1 through SP3 and supply the sensing signals to the display drivers 520.

The first voltage lines VDL may extend in the second direction DR2 and may be spaced apart from each other in the first direction DR1. The first voltage lines VDL may supply driving voltages or high potential voltages received from the power supply 550 to the first through third pixels SP1 through SP3.

The horizontal voltage lines HVDL may extend in the first direction DR1 and may be spaced apart from each other in the second direction DR2. The horizontal voltage lines HVDL may be connected to the first voltage lines VDL. The horizontal voltage lines HVDL may receive driving voltages or high potential voltages from the first voltage lines VDL.

The vertical voltage lines VVSL may extend in the second direction DR2 and may be spaced apart from each other in the first direction DR1. The vertical voltage lines VVSL may be connected to the second voltage lines VSL. The vertical voltage lines VVSL may supply low potential voltages received from the power supply 550 to the second voltage lines VSL.

The second voltage lines VSL may extend in the first direction DR1 and may be spaced apart from each other in the second direction DR2. The second voltage lines VSL may supply low potential voltages to the first through third pixels SP1 through SP3.

The connection relationship between the pixels SP, the gate lines GL, the data lines DL, the initialization voltage lines VIL, the first voltage lines VDL, the horizontal voltage lines HVDL, the vertical voltage lines VVSL, and the second voltage lines VSL can be variously designed and changed according to the number and arrangement of the pixels SP.

The non-display area NDA may be defined as an area other than the display area DA in the display substrate 100. For example, the non-display area NDA may include fan-out lines connecting the data lines DL, the initialization voltage lines VIL, the first voltage lines VDL and the vertical voltage lines VVSL to the display drivers 520 and may include the gate drivers 560 and the wiring pads WPD connected to the connection films 510.

The non-display area NDA may include a pad area PDA where the wiring pads WPD are disposed. The pad area PDA may be located adjacent to a side of the display device 10. For example, the pad area PDA may be located adjacent to a lower side of the display device 10. In an embodiment, the pad area PDA may extend along the first direction DR1.

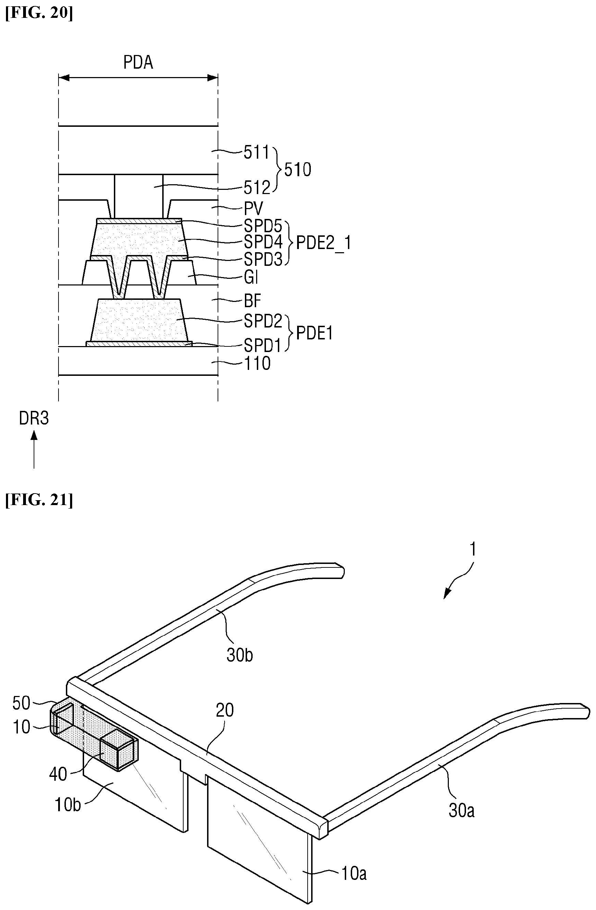

The connection films 510 may be connected to the wiring pads WPD disposed on a lower side of the non-display area NDA and board pads BPD disposed on an upper side of the circuit board 530. Input terminals, e.g., bumps 512 (see FIG. 20) disposed on one side and the other side of the connection films 510 may be attached to the wiring pads WPD and the board pads BPD by a film attaching process. For example, each of the connection films 510 may be bendable like a tape carrier package or a chip on film. The connection films 510 may be bent toward the bottom of the display substrate 100 to reduce a bezel area of the display device 10.

The display drivers 520 may be mounted on the connection films 510. For example, the display drivers 520 may be implemented as integrated circuits (ICs). The display drivers 520 may receive digital video data and a data control signal from the timing controller 540, convert the digital video data into analog data voltages according to the data control signal, and supply the analog data voltages to the data lines DL through the fan out lines.

The circuit board 530 may support the timing controller 540 and the power supply 550 and supply signals and power to the display drivers 520. For example, the circuit board 530 may supply signals supplied from the timing controller 540 and power supply voltages supplied from the power supply 550 to the connection films 510 and the display drivers 520 through the board pads BPD in order to display an image in each pixel. To this end, signal lines and power lines may be provided on the circuit board 530.

The timing controller 540 may be mounted on the circuit board 530 and may receive image data and a timing synchronization signal from a display driving system or a graphics device through a user connector provided on the circuit board 530. The timing controller 540 may generate digital video data by arranging the image data according to the pixel arrangement structure based on the timing synchronization signal and supply the generated digital video data to the display drivers 520. The timing controller 540 may generate a data control signal and a gate control signal based on the timing synchronization signal. The timing controller 540 may control the data voltage supply timing of the display drivers 520 based on the data control signal and may control the gate signal supply timing of the gate drivers 560 based on the gate control signal.

The power supply 550 may be disposed on the circuit board 530 to supply a power supply voltage to the connection films 510 and the display drivers 520. For example, the power supply 550 may generate a driving voltage or a high potential voltage and supply the driving voltage or the high potential voltage to the first voltage lines VDL, may generate a low potential voltage and supply the low potential voltage to the vertical voltage lines VVSL, and may generate an initialization voltage and supply the initialization voltage to the initialization voltage lines VIL.

The gate drivers 560 may be disposed on at least any one of left and right sides of the non-display area NDA. The gate drivers 560 may generate gate signals based on a gate control signal supplied from the timing controller 540. The gate control signal may include, but is not limited to, a start signal, a clock signal, and a power supply voltage. The gate drivers 560 may supply the gate signals to the gate lines GL according to a set order.

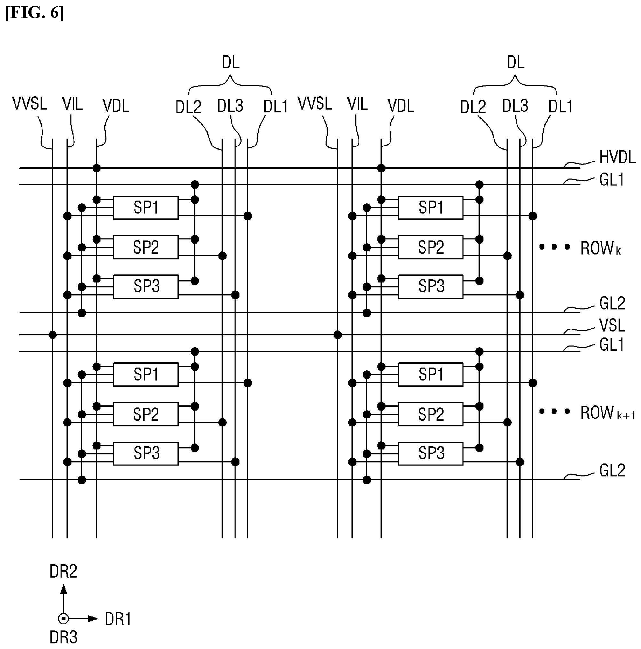

FIG. 6 illustrates pixels and lines of the display device according to the embodiment.

Referring to FIG. 6 in addition to FIGS. 4 and 5, the pixels SP may include the first through third pixels SP1 through SP3. The pixel circuits of the first pixels SP1, the pixel circuits of the second pixels SP2, and the pixel circuits of the third pixels SP3 may be sequentially arranged in the direction opposite to the second direction DR2, but the order of the pixel circuits is not limited thereto.

Each of the first through third pixels SP1 through SP3 may be connected to a first voltage line VDL, an initialization voltage line VIL, a gate line GL, and a data line DL.

The first voltage lines VDL may extend in the second direction DR2. The first voltage lines VDL may be disposed on left sides of the pixel circuits of the first through third pixels SP1 through SP3. The first voltage lines VDL may supply a driving voltage or a high potential voltage to transistors of the first through third pixels SP1 through SP3.

A horizontal voltage line HVDL may extend in the first direction DR1. The horizontal voltage line HVDL may be disposed above a first gate line GL1 disposed in a k^{th} row ROWₖ (where *k* is a positive integer). The horizontal voltage line HVDL may be connected to the first voltage lines VDL. The horizontal voltage line HVDL may receive driving voltages or high potential voltages from the first voltage lines VDL.

The initialization voltage lines VIL may extend in the second direction DR2. The initialization voltage lines VIL may be disposed on left sides of vertical auxiliary lines branching from each second gate line GL2 in the second direction DR2. The initialization voltage lines VIL may be disposed between the auxiliary lines, which branch from each second gate line GL2 in the second direction DR2, and the vertical voltage lines VVSL. The initialization voltage lines VIL may supply an initialization voltage to the pixel circuit of each of the first through third pixels SP1 through SP3. The initialization voltage lines VIL may receive a sensing signal from the pixel circuit of each of the first through third pixels SP1 through SP3 and supply the sensing signal to the display drivers 520.

The vertical voltage lines VVSL may extend in the second direction DR2. The vertical voltage lines VVSL may be disposed on left sides of the initialization voltage lines VIL. The vertical voltage lines VVSL may be connected between the power supply 550 and a second voltage line VSL. The vertical voltage lines VVSL may supply a low potential voltage received from the power supply 550 to the second voltage line VSL.

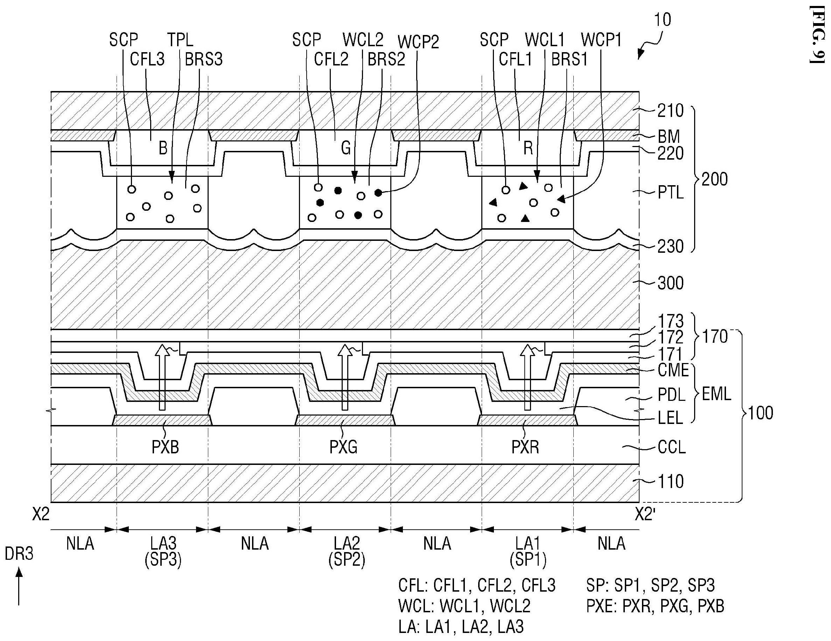

The second voltage line VSL may extend in the first direction DR1. The second voltage line VSL may be disposed above a first gate line GL1 disposed in a (k+1)^{th} row ROWₖ₊₁. The second voltage line VSL may supply a low potential voltage received from the vertical voltage lines VVSL to a light emitting element layer EML (see FIG. 9) of the first through third pixels SP1 through SP3.

The first gate lines GL1 may extend in the first direction DR1. The first gate lines GL1 may be disposed above the pixel circuits of the first pixels SP1. At least a portion of each first gate line GL1 may extend in the direction opposite to the second direction DR2. For example, each of the first gate lines GL1 may include vertical auxiliary lines branching on right sides of the first through third pixels SP1 through SP3 and extending in the direction opposite to the second direction DR2. The auxiliary lines of each of the first gate lines GL1 may be disposed on the right sides of the pixel circuits of the first through third pixels SP1 through SP3. Each of the first gate lines GL1 may supply a first gate signal received from the gate drivers 560 to the pixel circuits of the first through third pixels SP1 through SP3 through the auxiliary lines extending in the direction opposite to the second direction DR2.

The second gate lines GL2 may extend in the first direction DR1. The second gate lines GL2 may be disposed below the pixel circuits of the third pixels SP3. At least a portion of each second gate line GL2 may extend in the second direction DR2. For example, each of the second gate lines GL2 may include vertical auxiliary lines branching on left sides of the first voltage lines VDL and extending in the second direction DR2. The auxiliary lines of each of the second gate lines GL2 may be disposed on the left sides of the first voltage lines VDL. Each of the second gate lines GL2 may supply a second gate signal received from the gate drivers 560 to the pixel circuits of the first through third pixels SP1 through SP3 through the auxiliary lines extending in the second direction DR2.

The data lines DL may extend in the second direction DR2. The data lines DL may supply data voltages to the pixels SP. The data lines DL may include the first through third data lines DL1 through DL3.

The second data lines DL2 may extend in the second direction DR2. The second data lines DL2 may be disposed on right sides of the auxiliary lines of each first gate line GL1. The second data lines DL2 may supply data voltages received from the display drivers 520 to the pixel circuits of the second pixels SP2.

The third data lines DL3 may extend in the second direction DR2. The third data lines DL3 may be disposed on right sides of the second data lines DL2. The third data lines DL3 may supply data voltages received from the display drivers 520 to the pixel circuits of the third pixels SP3.

The first data lines DL1 may extend in the second direction DR2. The first data lines DL1 may be disposed on right sides of the third data lines DL3. The first data lines DL1 may supply data voltages received from the display drivers 520 to the pixel circuits of the first pixels SP1.

In the drawings, the second data lines DL2, the third data lines DL3, and the first data lines DL1 are sequentially arranged in the first direction DR1, but are not limited thereto. The order in which the first through third data lines DL1 through DL3 are arranged in the first direction DR1 can be variously changed.

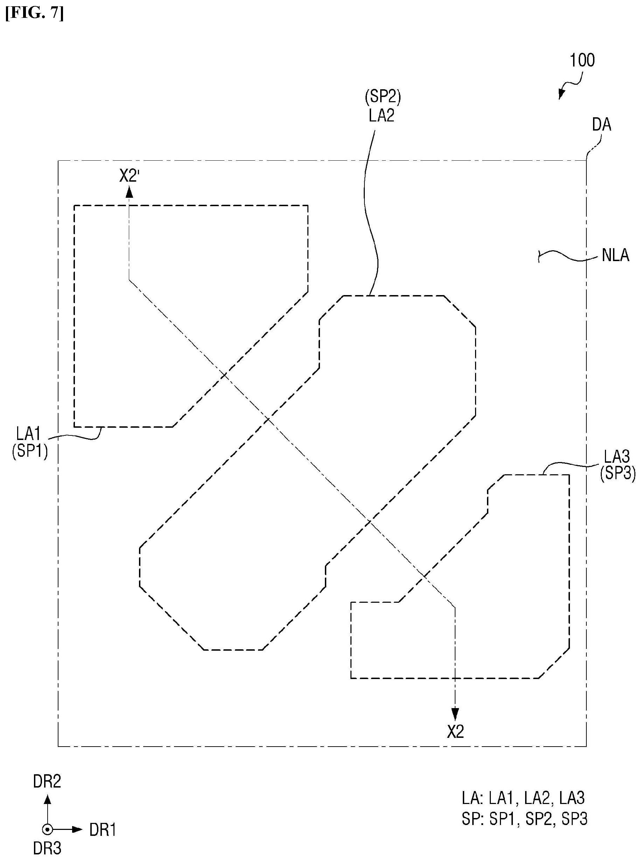

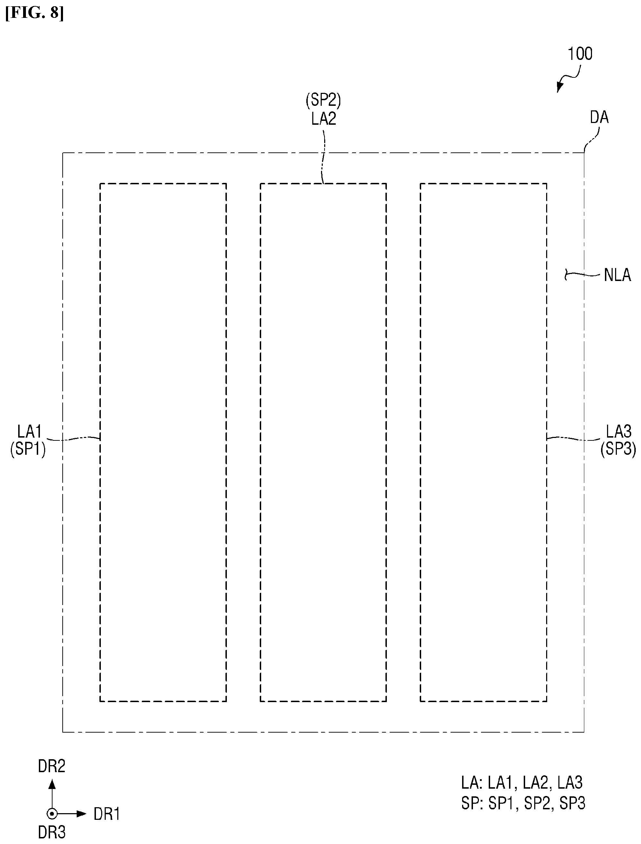

FIG. 7 is a schematic plan view of a part of the display area of the display substrate according to an embodiment. FIG. 8 is a schematic plan view of a part of a display area of a display substrate according to an embodiment.

Referring to FIGS. 7 and 8 in addition to FIGS. 1 through 3, a plurality of emission areas LA and a non-emission area NLA may be defined in the display area DA of the display substrate 100. The emission areas LA may be areas where light generated by light emitting elements of the display substrate 100 is emitted to the outside of the display substrate 100, and the non-emission area NLA may be an area where light generated by the light emitting elements of the display substrate 100 is not emitted to the outside of the display substrate 100. In some embodiments, the emission areas LA may include a first emission area LA1, a second emission area LA2, and a third emission area LA3.

In some embodiments, the emission areas LA and the non-emission area NLA may be defined by a pixel defining layer PDL (see FIG. 9). For example, the emission areas LA may be areas overlapping openings of the pixel defining layer PDL (see FIG. 9), and the non-emission area NLA may be an area not overlapping the openings of the pixel defining layer PDL (see FIG. 9).

In an embodiment, light emitted from the emission areas LA of the display substrate 100 to the color conversion substrate 200 may be light of the third color. For example, the light of the third color may be blue light and may have a peak wavelength in the range of about 440 to about 480 nm. The peak wavelength may refer to a wavelength having maximum intensity in a wavelength region. However, the present invention is not limited thereto, and the light emitted from the emission areas LA of the display substrate 100 to the color conversion substrate 200 may also be light in an ultraviolet region.

When the first through third emission areas LA1 through LA3 emit light of the same color, the first through third pixels SP1 through SP3 may express various colors through color conversion patterns included in the color conversion substrate 200.

In an embodiment, the first through third emission areas LA1 through LA3 may emit light of different colors. For example, light emitted from the first emission area LA1 may be red light, light emitted from the second emission area LA2 may be green light, and light emitted from the third emission area LA3 may be blue light.

The first emission area LA1, the second emission area LA2, and the third emission area LA3 may constitute a first pixel SP1, a second pixel SP2, and a third pixel SP3, respectively. The first emission area LA1, the second emission area LA2, and the third emission area LA3 may be repeatedly disposed over the entire display area DA along the first direction DR1 and the second direction DR2. The first emission area LA1, the second emission area LA2, and the third emission area LA3 may constitute one unit color pixel.

In an embodiment, as illustrated in FIG. 7, the first through third emission areas LA1 through LA3 may be disposed in a diagonal direction defined by the directions opposite to the first direction DR1 and the second direction DR2. For example, in one unit color pixel, the first emission area LA1 may be generally disposed at an upper left corner in plan view, the second emission area LA2 may be generally disposed at the center in plan view, and the third emission area LA3 may be generally disposed at a lower right corner in plan view. However, the arrangement order of the first through third emission areas LA1 through LA3 is not limited thereto.

In an embodiment, as illustrated in FIG. 8, the first through third emission areas LA1 through LA3 may be arranged along the first direction DR1. For example, in one unit color pixel, the first emission area LA1 may be generally disposed on the left side in plan view, the second emission area LA2 may be generally disposed at the center in plan view, and the third emission area LA2 may be generally disposed on the right side in plan view. However, the arrangement order of the first through third emission areas LA1 through LA3 is not limited thereto.

In an embodiment, as illustrated in FIG. 7, the first emission area LA1 may have a polygonal shape extending in the first direction DR1 and the second direction DR2. In the drawing, a pentagon is illustrated as an example of the shape of the first emission area LA1. The second emission area LA2 may have a polygonal shape extending in a diagonal direction defined by the first direction DR1 and the second direction DR2. In the drawing, a polygon having steps at both ends is illustrated as an example of the shape of the second emission area LA2. The third emission area LA3 may have a polygonal shape extending in the first direction DR1 and the second direction DR2. In the drawing, a polygon including portions protruding in the direction opposite to the first direction DR1 and in the second direction DR2 is illustrated as an example of the shape of the third emission area LA3.

In another embodiment, as illustrated in FIG. 8, the first through third emission areas LA1 through LA3 may have a polygonal shape extending in the second direction DR2. In the drawing, a quadrilateral is illustrated as an example of the shape of each of the first through third emission areas LA1 through LA3. However, the shapes of the first through third emission areas LA1 through LA3 are not limited thereto.

In an embodiment, as illustrated in FIG. 7, the widths and shapes of the first through third emission areas LA1 through LA3 may be different from each other. For example, the first emission area LA1 may have similar widths in the first direction DR1 and the second direction DR2. The second emission area LA2 may have a wide width in each diagonal direction defined by the first direction DR1 and the second direction DR2 and may have a narrow width in each diagonal direction defined by the directions opposite to the first direction DR1 and the second direction DR2. Therefore, the second emission area LA2 may be shaped like a polygon generally extending in the diagonal direction defined by the first direction DR1 and the second direction DR2. The third emission area LA3 may have similar widths in the first direction DR1 and the second direction DR2.

In another embodiment, as illustrated in FIG. 8, the widths and shapes of the first through third emission areas LA1 through LA3 may be the same. For example, the widths of the first through third emission areas LA1 through LA3 in the first direction DR1 may be the same, and the widths of the first through third emission areas LA1 through LA3 in the second direction DR2 may be the same.

The non-emission area NLA may be located around the emission areas LA of the display substrate 100 in the display area DA. The non-emission area NLA may be located not only around the emission areas LA, but also between the first emission area LA1 and the second emission area LA2, between the second emission area LA2 and the third emission area LA3, and between the third emission area LA3 and the first emission area LA1.

Light emitted from the emission areas LA of the display substrate 100 may pass through light transmitting areas of the color conversion substrate 200 and then may be provided to the outside of the display device 10.

FIG. 9 is a cross-sectional view taken along line X2-X2 of FIG. 8.

Referring to FIG. 9 in addition to FIGS. 7 and 8, the display device 10 may include the display substrate 100, the color conversion substrate 200 facing the display substrate 100, and the filler 300 bonding the display substrate 100 and the color conversion substrate 200 together.

The display substrate 100 may include a first substrate 110, a circuit layer CCL, a light emitting element layer EML, and an encapsulation structure 170.

The first substrate 110 may include a transparent material. For example, the first substrate 110 may include a transparent insulating material such as glass or quartz. The first substrate 110 may be a rigid substrate. However, the first substrate 110 is not limited thereto. The first substrate 110 may also include plastic such as polyimide or may have flexible properties so that it can be curved, bent, folded, or rolled.

The circuit layer CCL (e.g., thin-film transistor layer) may be disposed on the first substrate 110. The circuit layer CCL will be described later with reference to FIG. 8, etc.

The light emitting element layer EML may be disposed on the circuit layer CCL. The light emitting element layer EML may include pixel electrodes PXE, the pixel defining layer PDL, a light emitting layer LEL, and a common electrode CME.

The pixel electrodes PXE may be first electrodes, e.g., anodes of light emitting diodes. The pixel electrodes PXE may have a stacked structure of a material layer having a high work function such as indium-tin-oxide (ITO), indium-zinc-oxide (IZO), zinc oxide (ZnO) or indium oxide (In₂O₃) and a reflective material layer such as silver (Ag), magnesium (Mg), aluminum (Al), platinum (Pt), lead (Pd), gold (Au), nickel (Ni), neodymium (Nd), iridium (Ir), chromium (Cr), lithium (Li), calcium (Ca) or a mixture thereof. The material layer having a high work function may be disposed on the reflective material layer so that it is located close to the light emitting layer LEL. The pixel electrodes PXE may have, but are not limited to, a multilayer structure of ITO/Mg, ITO/MgF, ITO/Ag, or ITO/Ag/ITO.

The pixel electrodes PXE may include a first pixel electrode PXR, a second pixel electrode PXG, and a third pixel electrode PXB. The first pixel electrode PXR may overlap the first emission area LA1. The second pixel electrode PXG may overlap the second emission area LA2. The third pixel electrode PXB may overlap the third emission area LA3.

The pixel defining layer PDL may be disposed on a surface of the first substrate 110 along the boundaries of the pixels SP. The pixel defining layer PDL may be disposed on the pixel electrodes PXE and may include openings exposing the pixel electrodes PXE. The emission areas LA and the non-emission area NLA may be defined by the pixel defining layer PDL and its openings.

The pixel defining layer PDL may include an organic insulating material such as polyacrylates resin, epoxy resin, phenolic resin, polyamides resin, polyimides resin, unsaturated polyesters resin, polyphenylenethers resin, polyphenylenesulfides resin, or benzocyclobutene (BCB). The pixel defining layer PDL may also include an inorganic material.

The light emitting layer LEL may be disposed on the pixel electrodes PXE exposed by the pixel defining layer PDL. The light emitting layer LEL may contact not only the pixel electrodes PXE, but also side and upper surfaces of the pixel defining layer PDL. The light emitting layer LEL may be connected without distinguishing between the emission areas LA and between the pixels SP. The light emitting layer LEL may be disposed over the entire surface without distinguishing between the emission areas LA and between the pixels SP. Accordingly, the light emitting layer LEL of the emission areas LA1 through LA3 may emit light having the same wavelength. For example, the light emitting layer LEL of the emission areas LA1 through LA3 may emit blue light or ultraviolet light, and a wavelength conversion layer WCL included in the color conversion substrate 200 to be described later may enable each pixel SP to display a corresponding color.

In an embodiment, light emitting layers LEL may be respectively disposed in the emission areas LA1 through LA3 separated by the pixel defining layer PDL. In this case, the light emitting layers LEL of the emission areas LA1 through LA3 may emit light having the same wavelength.

In an embodiment in which the display device 10 is an organic light emitting display device, the light emitting layer LEL may include an organic layer including an organic material. The organic layer may include an organic light emitting layer. In some cases, the organic layer may further include at least one of a hole injection layer, a hole transport layer, an electron transport layer, and an electron injection layer as an auxiliary layer for assisting light emission. In an embodiment, when the display device 10 is a micro-LED display device or a nano-LED display device, the light emitting layer LEL may include an inorganic material such as an inorganic semiconductor.

In some embodiments, the light emitting layer LEL may have a tandem structure including a plurality of organic light emitting layers overlapping each other in a thickness direction and a charge generation layer disposed between them. The organic light emitting layers overlapping each other may emit light of the same wavelength or may emit light of different wavelengths. At least some layers of the light emitting layer LEL of each pixel SP may be separated from those of the light emitting layer LEL of a neighboring pixel SP by the pixel defining layer PDL or may be connected to those of the light emitting layer LEL of the neighboring pixel SP.

The common electrode CME may be disposed on the light emitting layer LEL. The common electrode CME may be connected without distinguishing between the emission areas LA and the pixels SP. The common electrode CME may be a whole-surface electrode disposed over the entire surface without distinguishing between the emission areas LA and between the pixels SP. The common electrode CME may be second electrodes, e.g., cathodes of the light emitting diodes. The common electrode CME may include a material layer having a small work function such as Li, Ca, LiF/Ca, LiF/Al, Al, Mg, Ag, Pt, Pd, Ni, Au Nd, Ir, Cr, BaF, Ba, or a compound or mixture thereof (e.g., a mixture of Ag and Mg). The common electrode CME may further include a transparent metal oxide layer disposed on the material layer having a small work function.

The pixel electrodes PXE, the light emitting layer LEL, and the common electrode CME may constitute light emitting elements (e.g., organic light emitting diodes). Light emitted from the light emitting layer LEL may be output upward through the common electrode CME.

The encapsulation structure 170 may be disposed on the common electrode CME. The encapsulation structure 170 may include at least one thin-film encapsulation layer. For example, the encapsulation structure 170 may include a first encapsulating inorganic layer 171, an encapsulating organic layer 172, and a second encapsulating inorganic layer 173.

The first encapsulating inorganic layer 171 may be disposed on the light emitting element layer EML. The first encapsulating inorganic layer 171 may include silicon nitride (SiNₓ), silicon oxide (SiOₓ), or silicon oxynitride (SiOₓN_{y}).

The encapsulating organic layer 172 may be disposed on the first encapsulating inorganic layer 171. The encapsulating organic layer 172 may include an organic insulating material such as polyacrylates resin, epoxy resin, phenolic resin, polyamides resin, polyimides resin, unsaturated polyesters resin, polyphenylenethers resin, polyphenylenesulfides resin, or benzocyclobutene (BCB).

The second encapsulating inorganic layer 173 may be disposed on the encapsulating organic layer 172. The second encapsulating inorganic layer 173 may include the same material as the first encapsulating inorganic layer 171 described above. For example, the second encapsulating inorganic layer 173 may include silicon nitride (SiNₓ), silicon oxide (SiOₓ), or silicon oxynitride (SiOₓN_{y}).

In some embodiments, some layers of the encapsulation structure 170 or the entire encapsulation structure 170 may be omitted. When the encapsulation structure 170 is omitted, the filler 300, the sealing part 400, and the color conversion substrate 200 may be directly disposed on the light emitting element layer EML and may perform an encapsulation function.

The color conversion substrate 200 may be disposed on the encapsulation structure 170 to face the display substrate 100. The color conversion substrate 200 may include a second substrate 210, a light blocking member BM, color filter layers CFL, a first capping layer 220, a partition wall PTL, a wavelength conversion layer WCL, a light transmitting layer TPL, and a second capping layer 230.

The second substrate 210 may include a transparent material. The second substrate 210 may include a transparent insulating material such as glass or quartz. The second substrate 210 may be a rigid substrate. However, the second substrate 210 is not limited thereto. The second substrate 210 may also include plastic such as polyimide or may have flexible properties so that it can be curved, bent, folded, or rolled.

The second substrate 210 may be the same substrate as the first substrate 110, but may have a different material, thickness, and transmittance from the first substrate 110. For example, the second substrate 210 may have higher transmittance than the first substrate 110. The second substrate 210 may be thicker or thinner than the first substrate 110.

The light blocking member BM may be disposed on a surface of the second substrate 210, which faces the first substrate 110, along the boundaries of the pixels SP. The light blocking member BM may overlap the pixel defining layer PDL of the display substrate 100 and may be located in the non-emission area NLA. The light blocking member BM may include openings exposing the surface of the second substrate 210 which overlaps the emission areas LA. The light blocking member BM may be formed in a lattice shape in plan view.

The light blocking member BM may include an organic material. The light blocking member BM may reduce color distortion due to reflection of external light by absorbing the external light. In addition, the light blocking member BM may reduce or prevent light emitted from the light emitting layer LEL from intruding into adjacent pixels SP.

In an embodiment, the light blocking member BM may absorb all visible light wavelengths. The light blocking member BM may include a light absorbing material. For example, the light blocking member BM may be made of a material used as a black matrix of the display device 10.

In an embodiment, the light blocking member BM may absorb light of a specific wavelength among the visible light wavelengths and transmit light of another specific wavelength. For example, the light blocking member BM may include the same material as a color filter layer CFL. Specifically, the light blocking member BM may be made of the same material as a blue color filter layer. In some embodiments, the light blocking member BM may be integrally formed with the blue color filter layer. The light blocking member BM may also be omitted.

The color filter layers CFL may be disposed on the surface of the second substrate 210 on which the light blocking member BM is disposed. The color filter layers CFL may be disposed on the surface of the second substrate 210 exposed through the openings of the light blocking member BM. Further, each of the color filter layers CFL may be disposed on a portion of the adjacent light blocking member BM.

The color filter layers CFL may include a first color filter layer CFL1 disposed in the first pixel SP1, a second color filter layer CFL2 disposed in the second pixel SP2, and a third color filter layer CFL3 disposed in the third pixel SP3. Each color filter layer CFL may include a colorant such as a dye or pigment that absorbs wavelengths other than a corresponding color wavelength. The first color filter layer CFL1 may be a red color filter layer, the second color filter layer CFL2 may be a green color filter, and the third color filter layer CFL3 may be a blue color filter layer. Although neighboring color filter layers CFL are spaced apart from each other on the light blocking member BM in the drawing, they may also at least partially overlap each other on the light blocking member BM.

The first capping layer 220 may be disposed on the color filter layers CFL. The first capping layer 220 may reduce or prevent damage to or contamination of the color filter layers CFL by reducing or preventing penetration of impurities such as moisture or air from the outside into the color filter layers CFL. In addition, the first capping layer 220 may reduce or prevent colorants of the color filter layer CFL from diffusing into other components.

The first capping layer 220 may directly contact surfaces (lower surfaces in FIG. 9) of the color filter layers CFL. The first capping layer 220 may be made of an inorganic material. For example, the first capping layer 220 may include silicon nitride, aluminum nitride, zirconium nitride, titanium nitride, hafnium nitride, tantalum nitride, silicon oxide, aluminum oxide, titanium oxide, tin oxide, or silicon oxynitride.

The partition wall PTL may be disposed on the first capping layer 220. The partition wall PTL may be located in the non-emission area NLA. The partition wall PTL may overlap the light blocking member BM. The partition wall PTL may include (or define) openings exposing the color filter layers CFL. The partition wall PTL may include, but is not limited to, a photosensitive organic material. The partition wall PTL may further include a light blocking material.

The wavelength conversion layer WCL and/or the light transmitting layer TPL may be disposed in spaces exposed by the openings of the partition wall PTL. The wavelength conversion layer WCL and the light transmitting layer TPL may be formed by an inkjet process using the partition wall PTL as a bank, but are not limited thereto.

In an embodiment in which the light emitting layer LEL of each pixel SP emits light of the third color, the wavelength conversion layer WCL may include a first wavelength conversion pattern WCL1 disposed in the first pixel SP1 and a second wavelength conversion pattern WCL2 disposed in the second pixel SP2. The light transmitting layer TPL may be disposed in the third pixel SP3.

The first wavelength conversion pattern WCL1 may include a first base resin BRS1 and first wavelength conversion materials WCP1 disposed in the first base resin BRS1. The second wavelength conversion pattern WCL2 may include a second base resin BRS2 and second wavelength conversion materials WCP2 disposed in the second base resin BRS2. The light transmitting layer TPL may include a third base resin BRS3 and scatterers SCP disposed in the third base resin BRS3.

The first through third base resins BRS1 through BRS3 may include a light-transmitting organic material. For example, the first through third base resins BRS1 through BRS3 may include epoxy resin, acrylic resin, cardo resin, or imide resin. The first through third base resins BRS1 through BRS3 may all be made of the same material, but are not limited thereto.

The scatterers SCP may be metal oxide particles or organic particles. The metal oxide may be, for example, titanium oxide (TiO₂), zirconium oxide (ZrO₂), aluminum oxide (Al₂O₃), indium oxide (In₂O₃), zinc oxide (ZnO) or tin oxide (SnO₂), and the organic particle material may be, for example, acrylic resin or urethane resin.

The first wavelength conversion materials WCP1 may convert the third color into the first color, and the second wavelength conversion materials WCP2 may convert the third color into the second color. The first wavelength conversion materials WCP1 and the second wavelength conversion materials WCP2 may be quantum dots, quantum rods, or phosphors. The quantum dots may include group IV nanocrystals, group II-VI compound nanocrystals, group III-V compound nanocrystals, group IV-VI nanocrystals, or a combination thereof. The first wavelength conversion pattern WCL1 and the second wavelength conversion pattern WCL2 may further include scatterers SCP to increase wavelength conversion efficiency.

The light transmitting layer TPL disposed in the third pixel SP3 may transmit light of the third color emitted from the light emitting layer LEL while maintaining the wavelength of the light. The scatterers SCP of the light transmitting layer TPL may control an emission path of light emitted through the light transmitting layer TPL. The light transmitting layer TPL may not include a wavelength conversion material.

The second capping layer 230 may be disposed on the wavelength conversion layer WCL, the light transmitting layer TPL, and the partition wall PTL. The second capping layer 230 may be made of an inorganic material. The second capping layer 230 may include a material selected from the materials listed as materials of the first capping layer 220. The second capping layer 230 and the first capping layer 220 may be made of the same material, but are not limited thereto.

The filler 300 may be disposed between the display substrate 100 and the color conversion substrate 200. The filler 300 may fill the space between the display substrate 100 and the color conversion substrate 200 and may bond and couple them to each other. The filler 300 may be disposed between the encapsulation structure 170 of the display substrate 100 and the second capping layer 230 of the color conversion substrate 200. The filler 300 may be made of, but not limited to, a Si-based organic material or an epoxy-based organic material.

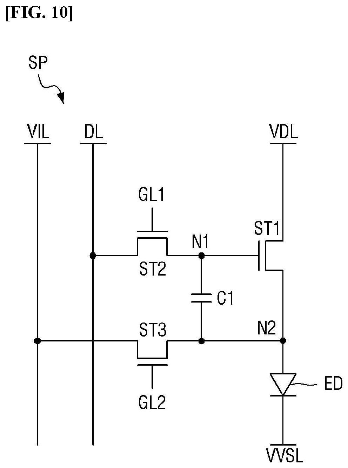

FIG. 10 is an equivalent circuit diagram of a pixel according to an embodiment.

Referring to FIG. 10, each pixel SP may be connected to a first voltage line VDL, a data line DL, an initialization voltage line VIL, a first gate line GL1, a second gate line GL2, and a vertical voltage line VVSL.

Each pixel SP may include a pixel circuit and a light emitting element ED. In an embodiment, as illustrated in the drawing, the pixel circuit of each pixel SP may have a 3T1C structure including three transistors and one capacitor. For example, the pixel circuit of each pixel SP may include first through third transistors ST1 through ST3 and a capacitor C1. However, the present invention is not limited thereto, and the number of transistors and capacitors in each pixel circuit can be variously changed. Although the 3T1C structure is described below as an example for ease of description, the present invention is not limited thereto, and other various modified structures such as a 2T1C structure, a 7T1C structure, a 6T1C structure, and a 17T3C structure are also applicable.

The first transistor ST1 may include a gate electrode, a drain electrode, and a source electrode. The first transistor ST1 may have the gate electrode connected to a first node N1, the drain electrode connected to the first voltage line VDL, and the source electrode connected to a second node N2. The first transistor ST1 may control a drain-source current (or a driving current) based on a data voltage applied to the gate electrode. The first transistor ST1 may be a driving transistor that drives the light emitting element ED.

The light emitting element ED may emit light in response to a driving current received. The amount of light emitted from the light emitting element ED or the luminance of the light emitting element ED may be proportional to the magnitude of the driving current. The light emitting element ED may be an organic light emitting diode including an organic light emitting layer, a quantum dot light emitting diode including a quantum dot light emitting layer, a micro light emitting diode, or an inorganic light emitting diode including an inorganic semiconductor.

A first electrode (e.g., pixel electrode) of the light emitting element ED may be connected to the second node N2, and a second electrode of the light emitting element ED may be connected to the vertical voltage line VVSL. The first electrode of the light emitting element ED may be connected to the source electrode of the first transistor ST1, a drain electrode of the third transistor ST3, and a first capacitor electrode of the capacitor C1 through the second node N2.

The second transistor ST2 may be turned on by a first gate signal of the first gate line GL1 to electrically connect the data line DL and the first node N1 which is the gate electrode of the first transistor ST1. The second transistor ST2 may be turned on based on the first gate signal to supply a data voltage to the first node N1. The second transistor ST2 may have a gate electrode connected to the first gate line GL1, a drain electrode connected to the data line DL, and a source electrode connected to the first node N1. The source electrode of the second transistor ST2 may be connected to the gate electrode of the first transistor ST1 and a second capacitor electrode of the capacitor C1 through the first node N1. The second transistor ST2 may be a switching transistor that controls a current flowing through the first transistor ST1 and the light emitting element ED.

The third transistor ST3 may be turned on by a second gate signal of the second gate line GL2 to electrically connect the initialization voltage line VIL and the second node N2 which is the source electrode of the first transistor ST1. The third transistor ST3 may be turned on based on the second gate signal to supply an initialization voltage to the second node N2. The third transistor ST3 may be turned on based on the second gate signal to supply a sensing signal to the initialization voltage line VIL. The third transistor ST3 may have a gate electrode connected to the second gate line GL2, the drain electrode connected to the second node N2, and a source electrode connected to the initialization voltage line VIL. The drain electrode of the third transistor ST3 may be connected to the source electrode of the first transistor ST1, the first capacitor electrode of the capacitor C1, and the first electrode of the light emitting element ED through the second node N2. The third transistor ST3 may be a switching transistor that controls a current flowing through the first transistor ST1 and the light emitting element ED.

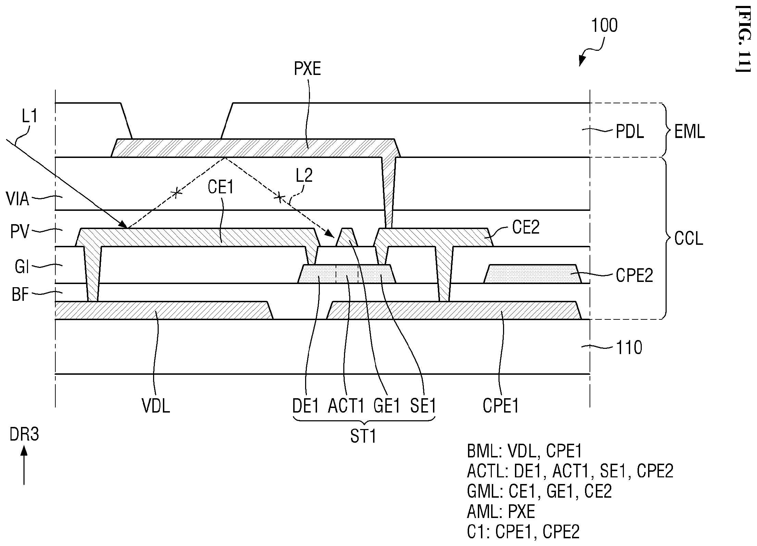

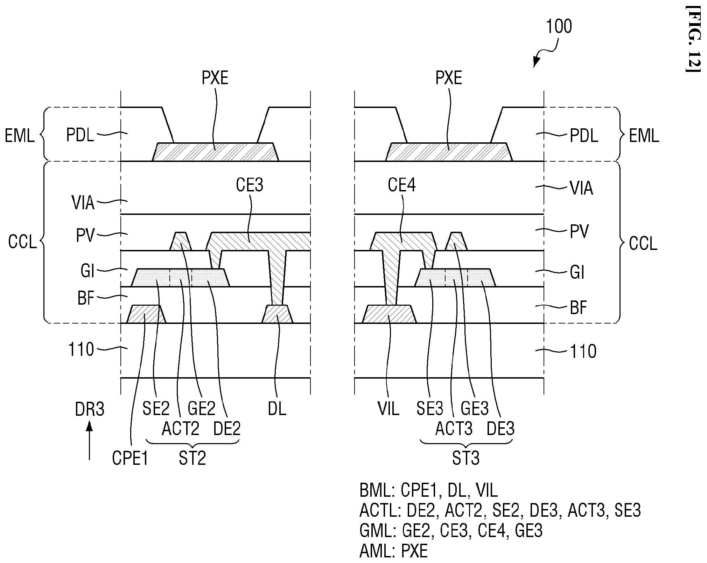

FIG. 11 is a cross-sectional view of an example of a first transistor of a circuit layer according to an embodiment. FIG. 12 is a cross-sectional view of an example of a second transistor and a third transistor of the circuit layer according to the embodiment.

Referring to FIGS. 11 and 12 in addition to FIG. 10, the display substrate 100 may include the first substrate 110, the circuit layer CCL, and the light emitting element layer EML.

Since the first substrate 110 has been described above with reference to FIG. 9, a description thereof will be omitted.

The circuit layer CCL may be disposed on the first substrate 110. The circuit layer CCL (e.g., thin-film transistor layer) may include a bottom conductive layer BML, a buffer layer BF, an active layer ACTL, a gate insulating layer GI, a gate conductive layer GML, a passivation layer PV, and a via layer VIA. The circuit layer CCL may include the first through third transistors ST1 through ST3 and a capacitor C1.

The bottom conductive layer BML may be disposed on the first substrate 110. The bottom conductive layer BML may include a single layer or a multilayer made of any one or more of molybdenum (Mo), aluminum (Al), chromium (Cr), gold (Au), titanium (Ti), nickel (Ni), neodymium (Nd), copper (Cu), and alloys thereof.

In an embodiment, the bottom conductive layer BML may include an initialization voltage line VIL, a data line DL, a first voltage line VDL, a vertical voltage line VVSL, and a first capacitor electrode CPE1 of the capacitor C1.

The buffer layer BF may be disposed on the bottom conductive layer BML. The buffer layer BF may include an inorganic material such as a silicon nitride layer, a silicon oxynitride layer, a silicon oxide layer, a titanium oxide layer, or an aluminum oxide layer. Alternatively, the buffer layer BF may include a multilayer in which a plurality of layers selected from a silicon nitride layer, a silicon oxynitride layer, a silicon oxide layer, a titanium oxide layer, and an aluminum oxide layer are alternately stacked.

The active layer ACTL may be disposed on the buffer layer BF. The active layer ACTL may include polycrystalline silicon, monocrystalline silicon, low-temperature polycrystalline silicon, amorphous silicon, or an oxide semiconductor material.

In an embodiment, the active layer ACTL may include a first active region ACT1, a first drain electrode DE1 and a first source electrode SE1 of the first transistor ST1, a second active region ACT2, a second drain electrode DE2 and a second source electrode SE2 of the second transistor ST2, a third active region ACT3, a third drain electrode DE3 and a third source electrode SE3 of the third transistor ST3, and a second capacitor electrode CPE2 of the capacitor C1.

The gate insulating layer GI may be disposed on the active layer ACTL. The gate insulating layer GI may include an inorganic layer such as a silicon nitride layer, a silicon oxynitride layer, a silicon oxide layer, a titanium oxide layer, or an aluminum oxide layer.

The gate conductive layer GML may be disposed on the gate insulating layer GI. The gate conductive layer GML may include a single layer or a multilayer made of any one or more of molybdenum (Mo), aluminum (Al), chromium (Cr), gold (Au), titanium (Ti), nickel (Ni), neodymium (Nd), copper (Cu), and alloys thereof.

In an embodiment, the gate conductive layer GML may include a first gate line GL1, a second gate line GL2, a first gate electrode GE1 of the first transistor ST1, a second gate electrode GE2 of the second transistor ST2, a third gate electrode GE3 of the third transistor ST3, and connection electrodes CE1 through CE4.

In the display device 10 according to the current embodiment, the gate conductive layer GML may have lower reflectivity than at least one of the bottom conductive layer BML and an anode conductive layer AML. The gate conductive layer GML may further include a material for lowering reflectivity. For example, the gate conductive layer GML may include aluminum-zinc-tin-oxide (AZTO).

First light L1, such as light coming from the outside or light emitted from an adjacent pixel, may be reflected from an upper surface of the gate conductive layer GML. Second light L2 reflected from the upper surface of the gate conductive layer GML may be reflected again from a lower surface of the anode conductive layer AML to enter the active layer ACTL. Accordingly, light-induced degradation may occur. The light-induced degradation refers to a phenomenon in which a characteristic curve between a drain-source current Ids and a gate voltage Vg of a transistor is shifted due to external light incident on the transistor, thus changing the magnitude of a threshold voltage Vth.

In the display device 10 according to the current embodiment, the gate conductive layer GML further including a material for lowering reflectivity can reduce reflected light such as the second light L2. Accordingly, the light-induced degradation can be reduced or minimized, thereby improving the reliability of the display device 10.

The passivation layer PV may be disposed on the gate conductive layer GML. The passivation layer PV may include an inorganic layer such as a silicon nitride layer, a silicon oxynitride layer, a silicon oxide layer, a titanium oxide layer, or an aluminum oxide layer.

The via layer VIA may be disposed on the passivation layer PV. The via layer VIA may include an organic layer such as acryl resin, epoxy resin, phenolic resin, polyamide resin, or polyimide resin.

The circuit layer CCL may include the first through third transistors ST1 through ST3 and the capacitor C1.

The first transistor ST1 may include the first active region ACT1, the first gate electrode GE1, the first drain electrode DE1, and the first source electrode SE1.

The first active region ACT1 may be disposed in the active layer ACTL. The first active region ACT1 may be overlapped by the first gate electrode GE1 in the third direction DR3. The first active region ACT1 may be a region where the active layer ACTL is not made conductive in an area overlapped by the first gate electrode GE1.

The first gate electrode GE1 may be disposed in the gate conductive layer GML. As illustrated in FIG. 10, the first gate electrode GE1 may be connected to the second source electrode SE2 of the second transistor ST2 and the second capacitor electrode CPE2 of the capacitor C1 through a first node N1.

In the drawings, the first transistor ST1 is illustrated as having a top gate structure in which the first gate electrode GE1 is disposed above the first active region ACT1. However, the present invention is not limited thereto. For example, the first transistor ST1 may also have a bottom gate structure in which the first gate electrode GE1 is disposed below the first active region ACT1. For another example, the first transistor ST1 may have a double gate structure in which the first gate electrode GE1 is disposed both above and below the first active region ACT1.

The first drain electrode DE1 and the first source electrode SE1 may be formed by heat-treating the active layer ACTL to make it conductive. The first drain electrode DE1 and the first source electrode SE1 may be, but are not limited to, P-type semiconductors or N-type semiconductors.

As illustrated in FIG. 10, the first drain electrode DE1 may be electrically connected to the first voltage line VDL. For example, as illustrated in FIG. 11, the first drain electrode DE1 may be connected to the first voltage line VDL through a first connection electrode CE1. Accordingly, the first drain electrode DE1 may receive a driving voltage from the first voltage line VDL.

As illustrated in FIG. 10, the first source electrode SE1 may be connected to a light emitting element ED through a second node N2. For example, as illustrated in FIG. 11, the first source electrode SE1 may be connected to a pixel electrode PXE through a second connection electrode CE2. Accordingly, the first source electrode SE1 may supply a driving current to the light emitting element ED.

As illustrated in FIG. 10, the first source electrode SE1 may be connected to the capacitor C1 through the second node N2. For example, as illustrated in FIG. 11, the first source electrode SE1 may be connected to the first capacitor electrode CPE1 of the capacitor C1 through the second connection electrode CE2.

The second transistor ST2 may include the second active region ACT2, the second gate electrode GE2, the second drain electrode DE2, and the second source electrode SE2.

The second active region ACT2 may be disposed in the active layer ACTL. The second active region ACT2 may be overlapped by the second gate electrode GE2 in the third direction DR3. The second active region ACT2 may be a region where the active layer ACTL is not made conductive in an area overlapped by the second gate electrode GE2.

The second gate electrode GE2 may be disposed in the gate conductive layer GML. As illustrated in FIG. 10, the second gate electrode GE2 may be connected to the first gate line GL1. Accordingly, the second gate electrode GE2 may receive a first gate signal from the first gate line GL1.

In the drawings, the second transistor ST2 is illustrated as having a top gate structure in which the second gate electrode GE2 is disposed above the second active region ACT2. However, the present invention is not limited thereto. For example, the second transistor ST2 may also have a bottom gate structure in which the second gate electrode GE2 is disposed below the second active region ACT2. For another example, the second transistor ST2 may have a double gate structure in which the second gate electrode GE2 is disposed both above and below the second active region ACT2.

The second drain electrode DE2 and the second source electrode SE2 may be formed by heat-treating the active layer ACTL to make it conductive. The second drain electrode DE2 and the second source electrode SE2 may be, but are not limited to, P-type semiconductors or N-type semiconductors.

As illustrated in FIG. 10, the second drain electrode DE2 may be electrically connected to the data line DL. For example, as illustrated in FIG. 12, the second drain electrode DE2 may be connected to the data line DL through a third connection electrode CE3. Accordingly, the second drain electrode DE2 may receive a data voltage from the data line DL.

As illustrated in FIG. 10, the second source electrode SE2 may be connected to the first gate electrode GE1 of the first transistor ST1 through the first node N1. Accordingly, the second source electrode SE2 may supply a data voltage to the first gate electrode GE1 of the first transistor ST1 through the first node N1. The first transistor ST1 may control a driving current based on the date voltage received from the second source electrode SE2.

As illustrated in FIG. 10, the second source electrode SE2 may be connected to the capacitor C1 through the first node N1. For example, although not illustrated in the drawings, the second source electrode SE2 may be connected to the second capacitor electrode CPE2 of the capacitor C1 through a separate connection electrode disposed in the gate conductive layer GML.

The third transistor ST3 may include the third active region ACT3, the third gate electrode GE3, the third drain electrode DE3, and the third source electrode SE3.

The third active region ACT3 may be disposed in the active layer ACTL. The third active region ACT3 may be overlapped by the third gate electrode GE3 in the third direction DR3. The third active region ACT3 may be a region where the active layer ACTL is not made conductive in an area overlapped by the third gate electrode GE3.

The third gate electrode GE3 may be disposed in the gate conductive layer GML. As illustrated in FIG. 10, the third gate electrode GE3 may be connected to the second gate line GL2. Accordingly, the third gate electrode GE3 may receive a second gate signal from the second gate line GL2.

In the drawings, the third transistor ST3 is illustrated as having a top gate structure in which the third gate electrode GE3 is disposed above the third active region ACT3. However, the present invention is not limited thereto. For example, the third transistor ST3 may also have a bottom gate structure in which the third gate electrode GE3 is disposed below the third active region ACT3. For another example, the third transistor ST3 may have a double gate structure in which the third gate electrode GE3 is disposed both above and below the third active region ACT3.

The third drain electrode DE3 and the third source electrode SE3 may be formed by heat-treating the active layer ACTL to make it conductive. The third drain electrode DE3 and the third source electrode SE3 may be, but are not limited to, P-type semiconductors or N-type semiconductors.

As illustrated in FIG. 10, the third drain electrode DE3 may be electrically connected to the first source electrode SE1 of the first transistor ST1. For example, although not illustrated in the drawings, the third drain electrode DE3 may be connected to the first source electrode SE1 of the first transistor ST1 through a separate connection electrode disposed in the gate conductive layer GML.

As illustrated in FIG. 10, the third drain electrode DE3 may be connected to the capacitor C1. For example, although not illustrated in the drawings, the third drain electrode DE3 may be connected to the first capacitor electrode CPE1 of the capacitor C1 through a separate connection electrode disposed in the gate conductive layer GML.

As illustrated in FIG. 10, the third source electrode SE3 may be connected to the initialization voltage line VIL. For example, as illustrated in FIG. 12, the third source electrode SE3 may be connected to the initialization voltage line VIL through a fourth connection electrode CE4. Accordingly, the third source electrode SE3 may receive an initialization voltage from the initialization voltage line VIL and supply a sensing signal to the initialization voltage line VIL.

The capacitor C1 may include the first capacitor electrode CPE1 and the second capacitor electrode CPE2.

The first capacitor electrode CPE1 may be disposed in the bottom conductive layer BML. The first capacitor electrode CPE1 may be connected to the first source electrode SE1 of the first transistor ST1 through the second connection electrode CE2. The first capacitor electrode CPE1 may be connected to the third drain electrode DE3 of the third transistor ST3 through a separate connection electrode disposed in the gate conductive layer GML.

The second capacitor electrode CPE2 may be disposed in the active layer ACTL. The second capacitor electrode CPE2 may be connected to the first gate electrode GE1 of the first transistor ST1 through a separate connection electrode disposed in the gate conductive layer GML. The second capacitor electrode CPE2 may be connected to the second source electrode SE2 of the second transistor ST2 through a separate connection electrode disposed in the gate conductive layer GML.

The light emitting element layer EML may include the anode conductive layer AML and the pixel defining layer PDL.

Since the pixel defining layer PDL has been described above with reference to FIG. 9, a description thereof will be omitted.

The anode conductive layer AML may be disposed on the circuit layer CCL. For example, the anode conductive layer AML may be disposed on the via layer VIA. In an embodiment, the anode conductive layer AML may include the pixel electrode PXE.

The anode conductive layer AML may have a stacked structure of a material layer having a high work function such as indium-tin-oxide (ITO), indium-zinc-oxide (IZO), zinc oxide (ZnO) or indium oxide (In₂O₃) and a reflective material layer such as silver (Ag), magnesium (Mg), aluminum (Al), platinum (Pt), lead (Pd), gold (Au), nickel (Ni), neodymium (Nd), iridium (Ir), chromium (Cr), lithium (Li), calcium (Ca) or a mixture thereof. The material layer having a high work function may be disposed on the reflective material layer so that it is located close to the light emitting layer LEL. The pixel electrode PXE may have, but is not limited to, a multilayer structure of ITO/Mg, ITO/MgF, ITO/Ag, or ITO/Ag/ITO.

In the display device 10 according to the current embodiment, the number of layers included in the circuit layer CCL is reduced or minimized to reduce the number of masks suitable to pattern each layer. Accordingly, process efficiency can be improved.

For example, lines such as the data lines DL, the initialization voltage lines VIL, the first voltage lines VDL, and the vertical voltage lines VVSL are placed in the bottom conductive layer MTL, and lines such as the gate lines GL, the horizontal voltage lines HVDL, and the second voltage lines VSL are placed in the gate conductive layer GML. Therefore, since a layer for placing the lines is not added, the number of layers can be reduced or minimized.

For another example, the first capacitor electrode CPE1 is placed in the bottom conductive layer MTL, and the second capacitor electrode CPE2 is placed in the active layer ACTL. Therefore, since a layer for placing the capacitor C1 is not added, the number of layers can be reduced or minimized.

For another example, connection electrodes for connecting the bottom conductive layer MTL, the active layer ACTL, and the gate conductive layer GML are placed in the gate conductive layer GML. Therefore, since a layer for placing the connection electrodes is not added, the number of layers can be reduced or minimized.

In the display device 10 according to the current embodiment, since the number of layers included in the circuit layer CCL is reduced or minimized, a distance between the light emitting element layer EML and the active layer ACTL in the third direction DR3 may be reduced. Accordingly, light coming from the outside or light emitted from an adjacent pixel may easily enter the active layer ACTL. In order to reduce or minimize the resultant light-induced degradation, the gate conductive layer GML of the display device 10 according to the current embodiment may include a reflectivity reduction structure.

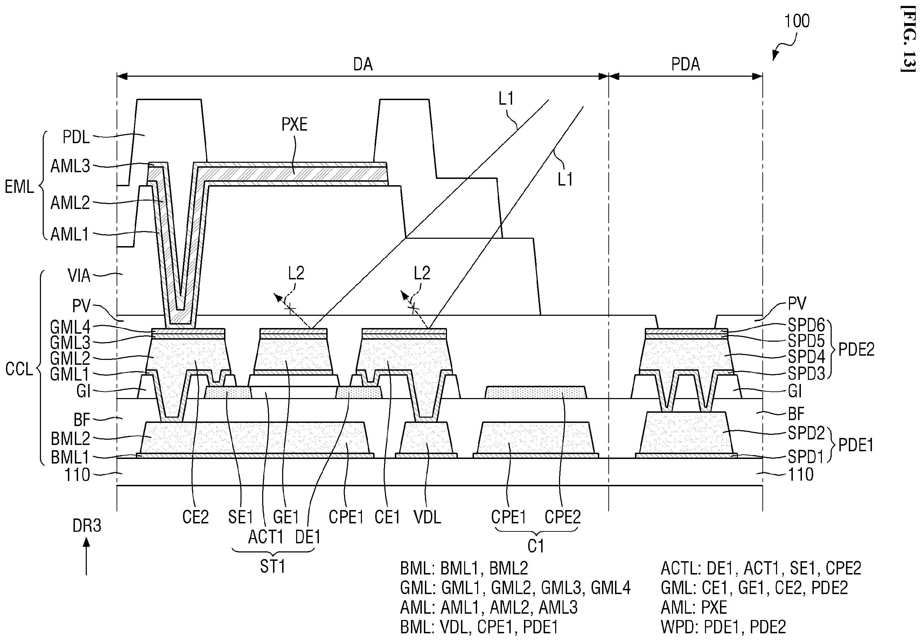

The reflectivity reduction structure of the gate conductive layer GML will now be described with reference to FIG. 13, etc.

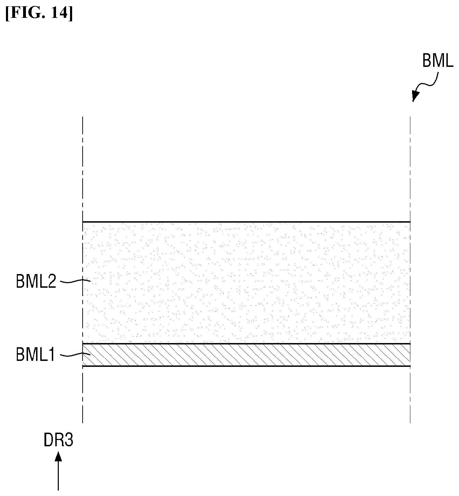

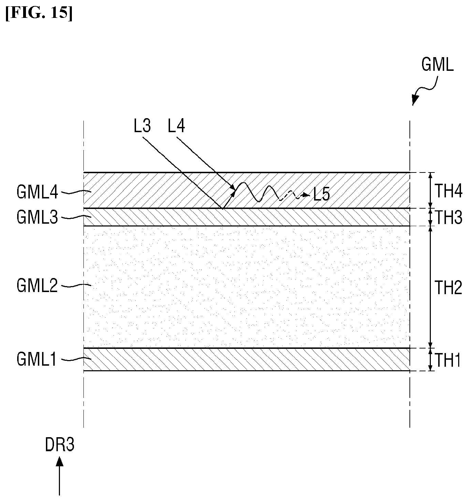

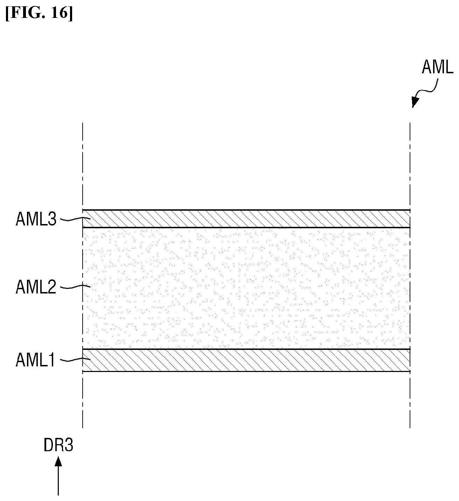

FIG. 13 is a cross-sectional view illustrating an example of a part of the display area and a part of the pad area of the display device according to the embodiment. FIG. 14 is a cross-sectional view of an example of a bottom conductive layer according to an embodiment. FIG. 15 is a cross-sectional view of an example of a gate conductive layer according to an embodiment. FIG. 16 is a cross-sectional view of an example of an anode conductive layer according to an embodiment.

FIG. 13 illustrates example cross-sections of a first transistor ST1 and a capacitor C1 in the display area DA and illustrates an example cross-section of a wiring pad WPD in the pad area PDA.

Referring to FIGS. 13 through 16, the display device 10 may include the display area DA and the pad area PDA. The display area DA is an area that displays an image and may be generally a central area of the display substrate 100. The pad area PDA may be an area where the wiring pad WPD is disposed. Since the display area DA and the pad area PDA have been described above with reference to FIG. 5, a description thereof will be omitted.

As illustrated in FIGS. 13 and 14, the bottom conductive layer BML may include a first bottom conductive layer BML1 and a second bottom conductive layer BML2.

The first bottom conductive layer BML1 may be disposed on the first substrate 110. The first bottom conductive layer BML1 may be a layer for improving adhesion between the first substrate 110 and the bottom conductive layer BML. For example, the first bottom conductive layer BML1 may include molybdenum (Mo), aluminum (Al), chromium (Cr), gold (Au), titanium (Ti), nickel (Ni), neodymium (Nd), copper (Cu), or an alloy thereof. Preferably, the first bottom conductive layer BML1 may include, but is not limited to, titanium (Ti).

The second bottom conductive layer BML2 may be disposed on the first bottom conductive layer BML1. The second bottom conductive layer BML2 may include a material with excellent electrical conductivity. For example, the third bottom conductive layer BML3 may include molybdenum (Mo), aluminum (Al), chromium (Cr), gold (Au), titanium (Ti), nickel (Ni), neodymium (Nd), copper (Cu), or an alloy thereof. Preferably, the second bottom conductive layer BML2 may include, but is not limited to, copper (Cu).

As illustrated in FIGS. 13 and 15, the gate conductive layer GML may include a first gate conductive layer GML1, a second gate conductive layer GML2, a third gate conductive layer GML3, and a fourth gate conductive layer GML4.

The first gate conductive layer GML1 may be disposed on the gate insulating layer GI. The first gate conductive layer GML1 may be a layer for improving adhesion between the gate insulating layer GI and the gate conductive layer GML. For example, the first gate conductive layer GML1 may include molybdenum (Mo), aluminum (Al), chromium (Cr), gold (Au), titanium (Ti), nickel (Ni), neodymium (Nd), copper (Cu), or an alloy thereof. Preferably, the first gate conductive layer GML1 may include, but is not limited to, titanium (Ti). In an embodiment, a thickness TH1 of the first gate conductive layer GML1 may be, but is not limited to, about 200 to 300 Å.

The second gate conductive layer GML2 may be disposed on the first gate conductive layer GML1. The second gate conductive layer GML2 may include a material with excellent electrical conductivity. For example, the second gate conductive layer GML2 may include molybdenum (Mo), aluminum (Al), chromium (Cr), gold (Au), titanium (Ti), nickel (Ni), neodymium (Nd), copper (Cu), or an alloy thereof. Preferably, the second gate conductive layer BML2 may include, but is not limited to, copper (Cu). In an embodiment, a thickness TH2 of the second gate conductive layer GML2 may be, but is not limited to, about 5000 to 10000 Å.

The third gate conductive layer GML3 may be disposed on the second gate conductive layer GML2. The third gate conductive layer GML3 may include a material with a high extinction coefficient and low reflectivity. For example, the third gate conductive layer GML3 may include molybdenum (Mo), aluminum (Al), chromium (Cr), gold (Au), titanium (Ti), nickel (Ni), neodymium (Nd), copper (Cu), or an alloy thereof. Preferably, the third gate conductive layer GML3 may include, but is not limited to, titanium (Ti). In an embodiment, a thickness TH3 of the third gate conductive layer GML3 may be, but is not limited to, about 100 to 200 Å.

The fourth gate conductive layer GML4 may be disposed on the third gate conductive layer GML3. The fourth gate conductive layer GML4 may include a material with high light transmittance. The fourth gate conductive layer GML4 may include transparent conductive oxide (TCO). For example, the fourth gate conductive layer GML4 may include aluminum-zinc-tin-oxide (AZTO).

In some embodiments, the fourth gate conductive layer GML4 may include about 1 to 10 at% of aluminum based on atoms excluding oxygen atoms. The fourth gate conductive layer GML4 may include about 60 to 90 at% of zinc based on the atoms excluding the oxygen atoms. The fourth gate conductive layer GML4 may include about 10 to 30 at% of tin based on the atoms excluding the oxygen atoms. Here, the respective ratios of aluminum, zinc, and tin included in the fourth gate conductive layer GML4 refer to the ratios of the numbers of individual particles of aluminum, zinc, and tin atoms to the total number of particles of the aluminum, zinc, and tin atoms which are the atoms excluding the oxygen atoms.

In some embodiments, the fourth gate conductive layer GML4 may include about 0.5 to 5 at% of aluminum based on total atoms including oxygen atoms. The fourth gate conductive layer GML4 may include about 20 to 40 at% of zinc based on the total atoms including the oxygen atoms. The fourth gate conductive layer GML4 may include about 7 to 15 at% of tin based on the total atoms including the oxygen atoms. The fourth gate conductive layer GML4 may include about 50 to 60 at% of oxygen based on the total atoms including the oxygen atoms. Here, the respective ratios of aluminum, zinc, tin, and oxygen included in the fourth gate conductive layer GML4 refer to the ratios of the numbers of individual particles of aluminum, zinc, tin, and oxygen atoms to the total number of particles of the aluminum, zinc, tin, and oxygen atoms.

In some embodiments, the reflectivity of the third gate conductive layer GML3 may be lower than the reflectivity of the fourth gate conductive layer GML4. The light transmittance of the fourth gate conductive layer GML4 may be higher than the light transmittance of the third gate conductive layer GML3.

In the display device 10 according to the current embodiment, the reflectivity of the gate conductive layer GML can be reduced by adjusting the thickness TH3 of the third gate conductive layer GML3 and a thickness TH4 of the fourth gate conductive layer GML4.

For example, as illustrated in FIG. 15, third light L3 incident on the gate conductive layer GML may pass through the fourth gate conductive layer GML4 and may be partially absorbed by the third gate conductive layer GML3. A portion of the third light L3 which is not absorbed by the third gate conductive layer GML3 may be reflected by the third gate conductive layer GML3 to destructively interfere with fourth light L4 incident later. The result may be fifth light L5 whose energy decreases or disappears. Accordingly, the reflectivity of the gate conductive layer GML may be reduced.

In some embodiments, the thickness TH4 of the fourth gate conductive layer GML4 may be greater than the thickness TH3 of the third gate conductive layer GML3. For example, the thickness TH4 of the fourth gate conductive layer GML4 may be about 2 to 30 times the thickness TH3 of the third gate conductive layer GML3.

In some embodiments, the thickness TH4 of the fourth gate conductive layer GML4 may be about 400 to 3000 Å. If the thickness TH4 of the fourth gate conductive layer GML4 is less than 400 Å, a reflectivity reduction effect may not occur. If the thickness TH4 of the fourth gate conductive layer GML4 exceeds 3000 Å, process efficiency may decrease, and the reliability of the conductive layer may decrease due to the heat applied during the process of forming the conductive layer. Preferably, the thickness TH4 of the fourth gate conductive layer GML4 may be about 400 to 1500 Å.

As illustrated in FIGS. 13 and 16, the anode conductive layer AML may include a first anode conductive layer AML1, a second anode conductive layer AML2, and a third anode conductive layer AML3.

The first anode conductive layer AML1 may be disposed on the via layer VIA. The second anode conductive layer AML2 may be disposed on the first anode conductive layer AML1. The third anode conductive layer AML3 may be disposed on the second anode conductive layer AML2.

The first anode conductive layer AML1 and the third anode conductive layer AML3 may include a material with a high work function and high light transmittance. For example, the first anode conductive layer AML1 and the third anode conductive layer AML3 may include at least any one of indium-tin-oxide (ITO), indium-zinc-oxide (IZO), zinc oxide (ZnO), and indium oxide (In₂O₃). Preferably, the first anode conductive layer AML1 and the third anode conductive layer AML3 may include, but are not limited to, indium-tin-oxide (ITO).

The second anode conductive layer AML2 may include a material with high reflectivity. For example, the second anode conductive layer AML2 may include silver (Ag), magnesium (Mg), aluminum (Al), platinum (Pt), lead (Pd), gold (Au), nickel (Ni), neodymium (Nd), iridium (Ir), chromium (Cr), lithium (Li), calcium (Ca), or a mixture thereof. Preferably, the second anode conductive layer AML2 may include, but is not limited to, silver (Ag).

In the display device 10 according to the current embodiment, since the third gate conductive layer GML3 includes a material with low reflectivity and the fourth gate conductive layer GML4 includes a material with high light transmittance, the gate conductive layer GML may have lower reflectivity than the bottom conductive layer BML and the anode conductive layer AML. Accordingly, it is possible to reduce or prevent light incident from the outside or light incident from an adjacent pixel from being reflected from the gate conductive layer GML and the anode conductive layer AML toward the active layer ACTL. Therefore, the light-induced degradation can be reduced or minimized.

The display device 10 may include the wiring pad WPD disposed in the pad area PDA. In some embodiments, the wiring pad WPD may include a first pad electrode PDE1 and a second pad electrode PDE2.

The first pad electrode PDE1 may be disposed in the bottom conductive layer BML. The first pad electrode PDE1 may include the same material as the bottom conductive layer BML of the display area DA. For example, the first pad electrode PDE1 may include a single layer or a multilayer made of any one or more of molybdenum (Mo), aluminum (Al), chromium (Cr), gold (Au), titanium (Ti), nickel (Ni), neodymium (Nd), copper (Cu), and alloys thereof.

In some embodiments, the first pad electrode PDE1 may include a first sub-pad SPD1 and a second sub-pad SPD2.

The first sub-pad SPD1 may be disposed in the first bottom conductive layer BML1. The first sub-pad SPD1 may include the same material as the first bottom conductive layer BML1 of the display area DA. For example, the first sub-pad SPD1 may include molybdenum (Mo), aluminum (Al), chromium (Cr), gold (Au), titanium (Ti), nickel (Ni), neodymium (Nd), copper (Cu), or an alloy thereof. Preferably, the first sub-pad SPD1 may include, but is not limited to, titanium (Ti).

The second sub-pad SPD2 may be disposed in the second bottom conductive layer BML2. The second sub-pad SPD2 may include the same material as the second bottom conductive layer BML2 of the display area DA. For example, the second sub-pad SPD2 may include molybdenum (Mo), aluminum (Al), chromium (Cr), gold (Au), titanium (Ti), nickel (Ni), neodymium (Nd), copper (Cu), or an alloy thereof. Preferably, the second sub-pad SPD2 may include, but is not limited to, copper (Cu).

The second pad electrode PDE2 may be disposed in the gate conductive layer GML. The second pad electrode PDE2 may include the same material as the gate conductive layer GML of the display area DA. For example, the second pad electrode PDE2 may include a single layer or a multilayer made of any one or more of molybdenum (Mo), aluminum (Al), chromium (Cr), gold (Au), titanium (Ti), nickel (Ni), neodymium (Nd), copper (Cu), and alloys thereof. In some embodiments, the second pad electrode PDE2 may include aluminum-zinc-tin-oxide (AZTO).

In some embodiments, the second pad electrode PDE2 may include a third sub-pad SPD3, a fourth sub-pad SPD4, a fifth sub-pad SPD5, and a sixth sub-pad SPD6.

The third sub-pad SPD3 may be disposed in the first gate conductive layer GML1. The third sub-pad SPD3 may include the same material as the first gate conductive layer GML1 of the display area DA. For example, the third sub-pad SPD3 may include molybdenum (Mo), aluminum (Al), chromium (Cr), gold (Au), titanium (Ti), nickel (Ni), neodymium (Nd), copper (Cu), or an alloy thereof. Preferably, the third sub-pad SPD3 may include, but is not limited to, titanium (Ti).

The fourth sub-pad SPD4 may be disposed in the second gate conductive layer GML2. The fourth sub-pad SPD4 may include the same material as the second gate conductive layer GML2 of the display area DA. For example, the fourth sub-pad SPD4 may include molybdenum (Mo), aluminum (Al), chromium (Cr), gold (Au), titanium (Ti), nickel (Ni), neodymium (Nd), copper (Cu), or an alloy thereof. Preferably, the fourth sub-pad SPD4 may include, but is not limited to, copper (Cu).

The fifth sub-pad SPD5 may be disposed in the third gate conductive layer GML3. The fifth sub-pad SPD5 may include the same material as the third gate conductive layer GML3 of the display area DA. For example, the fifth sub-pad SPD5 may include molybdenum (Mo), aluminum (Al), chromium (Cr), gold (Au), titanium (Ti), nickel (Ni), neodymium (Nd), copper (Cu), or an alloy thereof. Preferably, the fifth sub-pad SPD5 may include, but is not limited to, titanium (Ti).

The sixth sub-pad SPD6 may be disposed in the fourth gate conductive layer GML4. The sixth sub-pad SPD6 may include the same material as the fourth gate conductive layer GML4 of the display area DA. For example, the sixth sub-pad SPD6 may include transparent conductive oxide (TCO). Preferably, the sixth sub-pad SPD6 may include aluminum-zinc-tin-oxide (AZTO).

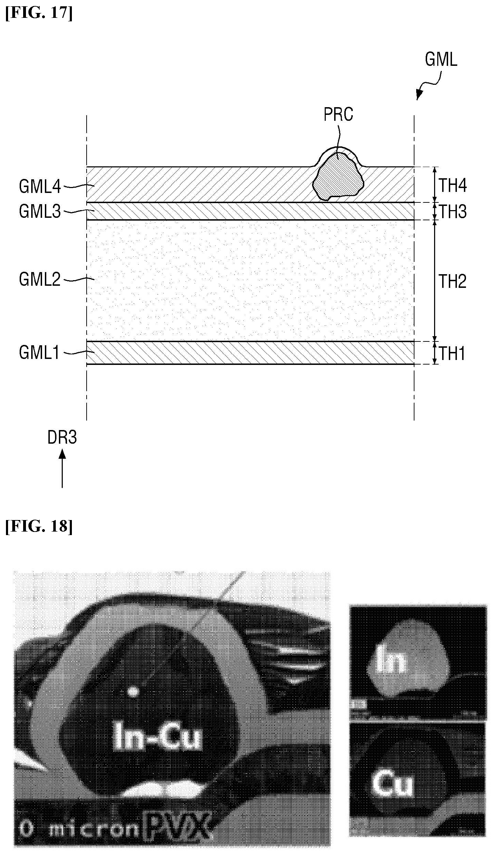

FIG. 17 is a cross-sectional view of an example of a conventional gate conductive layer. FIG. 18 is a photograph showing a precipitated particle formed on a cross section of the conventional gate conductive layer.

Referring to FIGS. 17 and 18 in addition to FIGS. 13 through 16, the gate conductive layer GML according to the current embodiment may not include indium. The conventional gate conductive layer GML may include indium. For example, a fourth gate conductive layer GML4 of the conventional gate conductive layer GML may include indium tin oxide (ITO). First through third gate conductive layers GML1 through GML3 of the conventional gate conductive layer GML may include the same materials as those of the gate conductive layer GML according to the current embodiment, respectively.

As illustrated in FIGS. 17 and 18, in the conventional gate conductive layer GML, since the fourth gate conductive layer GML includes indium, a precipitated particle PRC may be formed.

For example, when the third gate conductive layer GML3 includes titanium, indium atoms of the fourth gate conductive layer GML4 may be precipitated in particle form due to a difference in binding energy (e.g., Gibbs free energy) between titanium oxide and indium oxide. Since titanium oxide has a lower Gibbs free energy than indium oxide, it may have a higher binding energy than indium oxide. Accordingly, oxygen atoms of indium-tin-oxide of the conventional fourth gate conductive layer GML4 may move toward titanium oxide due to high temperature generated in the process of forming a passivation layer PV or a via layer VIA on the gate conductive layer GML. Accordingly, the precipitated particle PRC may be formed in the fourth gate conductive layer GML.

As illustrated in FIG. 18, in a conventional display device 10, if the second gate conductive layer GML includes copper, when indium atoms are precipitated, indium atoms and copper atoms may be combined to produce an indium-copper alloy as the precipitated particle PRC.

Since the gate conductive layer GML according to the current embodiment does not include indium, the formation of the precipitated particle PRC including indium metal or indium-copper alloy can be prevented. Accordingly, the reliability of the gate conductive layer GML can be improved.

Hereinafter, first and second comparative examples and a first example will be compared and described with reference to Table 1 below. The first and second comparative examples may be the conventional gate conductive layer GML described above, and the first example may be the gate conductive layer GML according to the current embodiment described above.

**[Table 1]**

| Example | Structure of Gate Conductive Layer (1^{st}/2^{nd}/3^{rd} /4^{th} layers) | Reflectivity according to Wavelength of Light | | |
|---|---|---|---|---|
| | | 450 nm | 550 nm | 650 nm |
| First comparative example | Ti/Cu/ITO | 35.4% | 22.3% | 62.7% |
| Second comparative example | Ti/Cu/Ti/ITO | 9.7% | 23.8% | 34% |
| First example | Ti/Cu/Ti/AZTO | 6.32% | 4.50% | 9.43% |

Referring to Table 1, a gate conductive layer GML according to the first comparative example may include a stacked structure of Ti/Cu/ITO, a gate conductive layer GML according to the second comparative example may include a stacked structure of Ti/Cu/Ti/ITO, and a gate conductive layer GML according to the first example may include a stacked structure of Ti/Cu/Ti/AZTO. In the stacked structure of Ti/Cu/ITO, the stacked structure of Ti/Cu/Ti/ITO, and the stacked structure of Ti/Cu/Ti/AZTO, the order from left to right indicates the order from a bottom layer to a top layer of a gate conductive layer GML.

Since the gate conductive layer GML according to the first comparative example does not include a Ti layer, the reflectivity reduction effect may hardly occur regardless of the wavelength of light.

Since the gate conductive layer GML according to the second comparative example includes a Ti layer, the reflectivity of the gate conductive layer GML according to the second comparative example for light having wavelengths of 450 nm and 650 nm may be lower than the reflectivity of the gate conductive layer GML according to the first comparative example for the light having the wavelengths of 450 nm and 650 nm. However, the reflectivity of the gate conductive layer GML according to the second comparative example for light having a wavelength of 550 nm may be higher than the reflectivity of the gate conductive layer GML according to the first comparative example for the light having the wavelength of 550 nm. In addition, since the gate conductive layer GML according to the second comparative example includes both a Ti layer and an ITO layer, the precipitated particle PRC may be formed as described above.

On the other hand, the gate conductive layer GML according to the first example may have lower reflectivity for light of all wavelengths than the gate conductive layers GML according to the first and second comparative examples. Since the gate conductive layer GML according to the first example includes a Ti layer and an AZTO layer, the reflectivity of the gate conductive layer GML can be reduced. In addition, since the gate conductive layer GML according to the first example does not include indium atoms, the precipitated particle PRC may not be formed, thus improving the reliability of the gate conductive layer GML.

Hereinafter, other embodiments of the display device 10 according to the embodiment will be described. In the following embodiments, the same elements as those of the above-described embodiment are identified by the same reference characters, and any redundant description thereof will be omitted or given briefly, and differences will mainly be described.

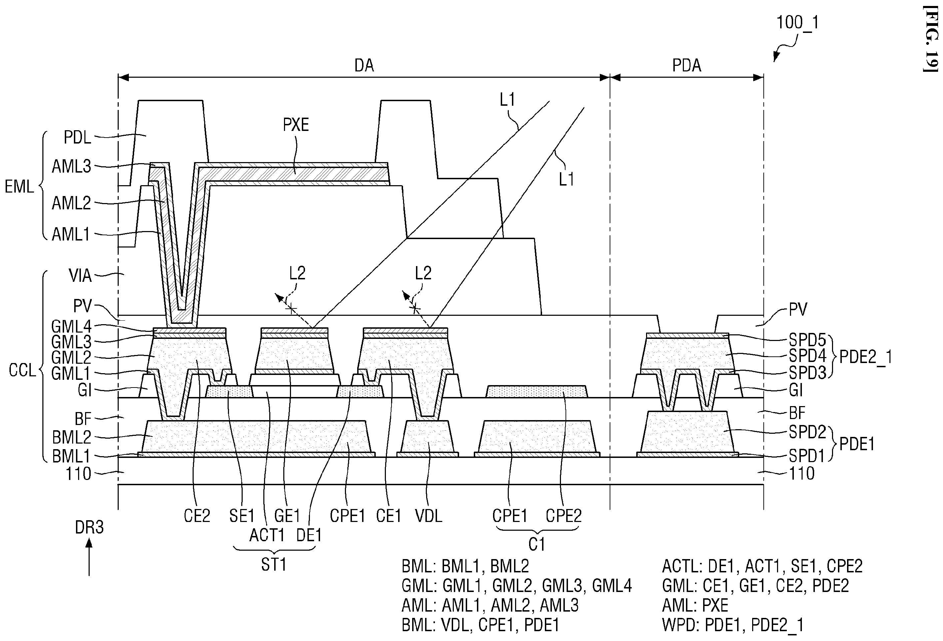

FIG. 19 is a cross-sectional view illustrating an example of a part of a display area and a part of a pad area of a display device according to an embodiment. FIG. 20 is a cross-sectional view illustrating a wiring pad and a flexible film of the display device according to the embodiment.

Referring to FIGS. 19 and 20, the display device 10 according to the current embodiment is different from the display device 10 according to the embodiment described with reference to FIG. 13, etc. in that it does not include a sixth sub-pad SPD6.

More specifically, in a display substrate 100_1 of the display device 10 according to the current embodiment, a second pad electrode PDE2_1 of the wiring pad WPD may not include the sixth sub-pad SPD6 (see FIG. 13). For example, an uppermost layer of the second pad electrode PDE2_1 of the wiring pad WPD may be a fifth sub-pad SPD5.

A passivation layer PV disposed on the wiring pad WPD may include a through hole for exposing the wiring pad WPD. The fifth sub-pad SPD5 may be exposed through the through hole of the passivation layer PV.

In some embodiments, the connection film 510 may include a base film 511 and a bump 512. The base film 511 may be a flexible circuit film on which components such as a display driver 520 (see FIG. 4) can be mounted. The bump 512 may be a conductive protrusion protruding from the base film 511 toward the wiring pad WPD. In the display device 10 according to the current embodiment, the bump 512 of the connection film 510 may directly contact the fifth sub-pad SPD5.

The sixth sub-pad SPD6 (see FIG. 13) of the display device 10 according to the embodiment described with reference to FIG. 13, etc. may include metal oxide. On the other hand, the fifth sub-pad SPD5 of the display device 10 according to the current embodiment may include metal. Therefore, the wiring pad WPD of the display device 10 according to the current embodiment may have better electrical characteristics than the display device 10 according to the embodiment described with reference to FIG. 13, etc. Accordingly, loss of signals and voltages that the display substrate 100_1 receives from the connection film 510 or provides to the connection film can be reduced or minimized.

In the drawings, a case where the connection film 510 is connected to the wiring pad WPD is illustrated as an example. However, the present invention is not limited thereto. For example, the same technical spirit can be applied even when the display driver 520 (see FIG. 4) and/or the circuit board 530 (see FIG. 4) described with reference to FIGS. 4 and 5 are connected to the wiring pad WPD. Components connected to the wiring pad WPD, such as the connection film 510, the display driver 520 (see FIG. 4) and the circuit board 530 (see FIG. 4), may be referred to as driving components.

FIGS. 21 through 23 are schematic perspective views of devices including a display device according to an embodiment.

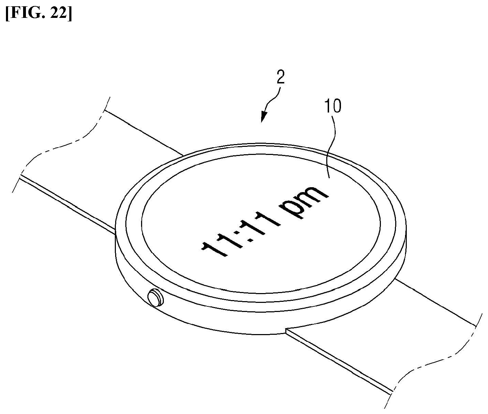

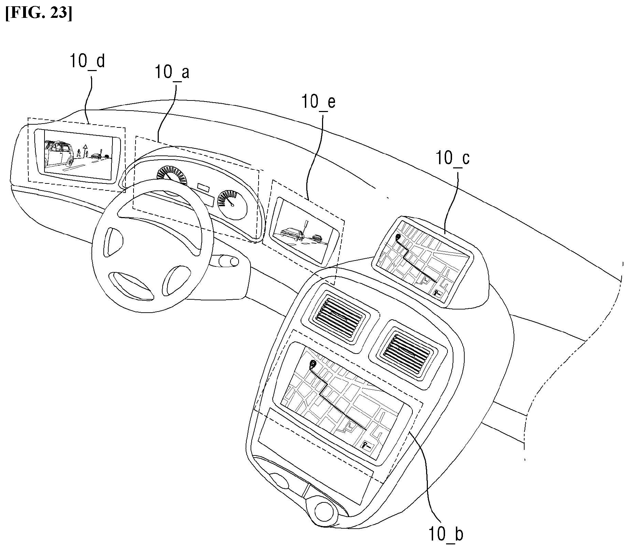

FIG. 21 illustrates a virtual reality (VR) device 1 to which a display device 10 according to an embodiment has been applied. FIG. 22 illustrates a smart watch 2 to which a display device 10 according to an embodiment has been applied. FIG. 23 illustrates display units of a vehicle to which display devices 10_a through 10_e according to an embodiment have been applied.

Referring to FIG. 21, the VR device 1 according to an embodiment may be a device in the form of glasses. The VR device 1 according to the embodiment may include a display device 10, a left lens 10a, a right lens 10b, a support frame 20, eyeglass frame legs 30a and 30b, a reflective member 40, and a display device housing 50.

In the drawing, the VR device 1 including the eyeglass frame legs 30a and 30b is illustrated as an example. However, the VR device 1 according to the embodiment can also be applied to a head-mounted display including a head-mounted band which can be worn on the head, instead of the eyeglass frame legs 30a and 30b. The VR device 1 according to the embodiment is not limited to the illustrated structure and can be applied in various forms to various other electronic devices.

The display device housing 50 may include the display device 10 and the reflective member 40. An image displayed on the display device 10 may be reflected by the reflective member 40 and provided to a user's right eye through the right lens 10b. Accordingly, the user can view a VR image displayed on the display device 10 through the right eye.

The display device housing 50 may be disposed at a right end of the support frame 20, but is not limited thereto. For example, the display device housing 50 may also be disposed at a left end of the support frame 20. In this case, an image displayed on the display device 10 may be reflected by the reflective member 40 and provided to the user's left eye through the left lens 10a. Accordingly, the user can view a VR image displayed on the display device 10 through the left eye. Alternatively, the display device housing 50 may be disposed at both the right end and the left end of the support frame 20. In this case, the user can view a VR image displayed on the display device 10 through both the left eye and the right eye.

Referring to FIG. 22, a display device 10 according to an embodiment may be applied to a smart watch 2 which is one of smart devices.

Referring to FIG. 23, display devices 10_a through 10_c according to an embodiment may be applied to a dashboard of a vehicle, a center fascia of the vehicle, or a center information display (CID) disposed on the dashboard of the vehicle. In addition, display devices 10_d and 10_e according to an embodiment may be applied to room mirror displays that replace side mirrors of the vehicle.

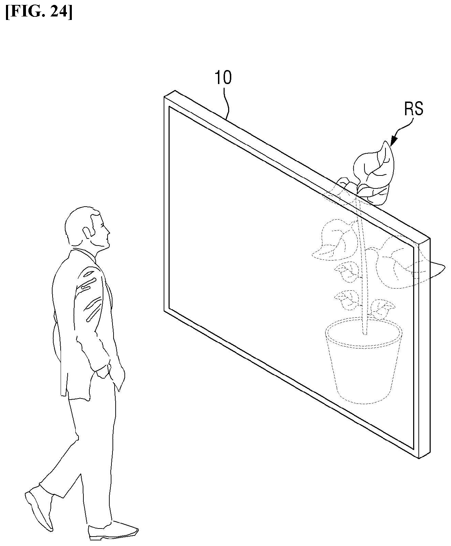

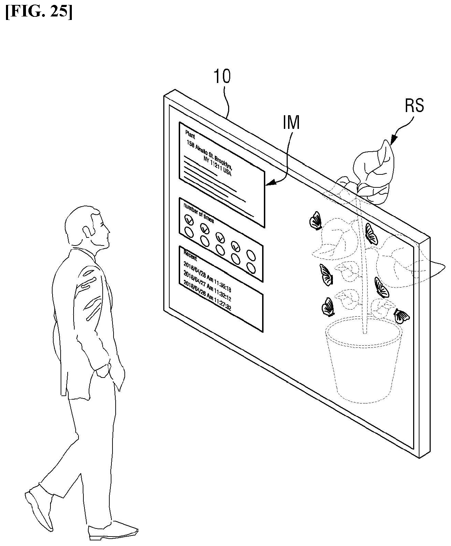

FIGS. 24 and 25 are schematic perspective views of a transparent display device including a display device according to an embodiment.

Referring to FIGS. 24 and 25, the display device 10 according to the embodiment may be applied to the transparent display device. The transparent display device may transmit light while displaying an image IM. A user located in front of the transparent display device can not only view the image IM displayed on the display device 10 but also view an object RS or the background located behind the transparent display device.

Although the embodiments of the present invention have been described above with reference to the accompanying drawings, a person having ordinary skill in the art to which the present invention pertains will understand that the present invention may be embodied in other specific forms without departing from the technical spirit or essential characteristics thereof. Therefore, the embodiments described above are to be considered in all respects as illustrative and not restrictive.

## Claims

1. A display device comprising:
a substrate;
a first conductive layer disposed on the substrate;
an active layer disposed on the first conductive layer;
a second conductive layer disposed on the active layer, and comprising a transparent conductive oxide (TCO) while not comprising indium (In);
a third conductive layer disposed on the second conductive layer;
a transistor comprising a gate electrode disposed in the second conductive layer and a drain electrode and a source electrode disposed in the active layer; and
a light emitting element comprising a first electrode disposed in the third conductive layer and connected to the source electrode.

2. The display device of claim 1, wherein the second conductive layer comprises aluminum-zinc-tin-oxide (AZTO).

3. The display device of claim 1, wherein
the second conductive layer comprises a first gate conductive layer and a second gate conductive layer disposed on the first gate conductive layer, and
the second gate conductive layer has higher light transmittance than the first gate conductive layer.

4. The display device of claim 3, wherein the second gate conductive layer comprises aluminum-zinc-tin-oxide (AZTO).

5. The display device of claim 4, wherein the second gate conductive layer comprises 1 to 10 at% of aluminum based on atoms excluding oxygen atoms.

6. The display device of claim 4, wherein the second gate conductive layer comprises 60 to 90 at% of zinc based on the atoms excluding the oxygen atoms.

7. The display device of claim 4, wherein the second gate conductive layer comprises 10 to 30 at% of tin based on the atoms excluding the oxygen atoms.

8. The display device of claim 4, wherein the second gate conductive layer comprises 0.5 to 5 at% of aluminum based on total atoms.

9. The display device of claim 4, wherein the second gate conductive layer comprises 20 to 40 at% of zinc based on the total atoms.

10. The display device of claim 4, wherein the second gate conductive layer comprises 7 to 15 at% of tin based on the total atoms.

11. The display device of claim 4, wherein the second gate conductive layer comprises 50 to 60 at% of oxygen based on the total atoms.

12. The display device of claim 3, wherein the first gate conductive layer has lower reflectivity than the second gate conductive layer.

13. The display device of claim 12, wherein the first gate conductive layer comprises titanium (Ti).

14. The display device of claim 3, wherein a thickness of the second gate conductive layer is greater than a thickness of the first gate conductive layer.

15. The display device of claim 14, wherein the thickness of the second gate conductive layer is 2 to 30 times the thickness of the first gate conductive layer.

16. The display device of claim 15, wherein the thickness of the second gate conductive layer is 400 to 3000 Å.

17. The display device of claim 15, wherein the thickness of the first gate conductive layer is 100 to 200 Å.

18. The display device of claim 1, wherein
the third conductive layer comprises transparent conductive oxide (TCO), and
the transparent conductive oxide (TCO) of the second conductive layer and the transparent conductive oxide (TCO) of the third conductive layer are different materials.

19. The display device of claim 1, wherein the second conductive layer has lower reflectivity than the first conductive layer or the third conductive layer.

20. A display device comprising:
a substrate;
a first conductive layer disposed on the substrate;
an active layer disposed on the first conductive layer;
a second conductive layer disposed on the active layer;
a transistor disposed on the first conductive layer; and
a light emitting element disposed on the second conductive layer and connected to the transistor,
wherein the second conductive layer comprises:
a first gate conductive layer comprising a first material;
a second gate conductive layer disposed on the first gate conductive layer and comprising a second material;
a third gate conductive layer disposed on the second gate conductive layer and comprising a third material; and
a fourth gate conductive layer disposed on the third gate conductive layer and comprising aluminum-zinc-tin-oxide (AZTO),
wherein the first through third materials comprise metal.

21. The display device of claim 20, wherein the first through third materials comprise molybdenum (Mo), aluminum (Al), chromium (Cr), gold (Au), titanium (Ti), nickel (Ni), neodymium (Nd), copper (Cu), or an alloy thereof.

22. The display device of claim 21, wherein the first material comprises titanium (Ti).

23. The display device of claim 21, wherein the second material comprises copper (Cu).

24. The display device of claim 21, wherein the third material comprises titanium (Ti).

25. The display device of claim 20, wherein a thickness of the fourth gate conductive layer is greater than a thickness of the third gate conductive layer.

26. The display device of claim 20, wherein a thickness of the second gate conductive layer is greater than the thickness of the fourth gate conductive layer.

27. A display device comprising:
a substrate comprising a display area and a pad area disposed on a side of the display area;
a first conductive layer disposed on the substrate;
an active layer disposed on the first conductive layer;
a second conductive layer disposed on the active layer, and comprising a transparent conductive oxide (TCO) while not comprising indium (In), in the display area;
a transistor disposed on the first conductive layer in the display area;
a light emitting element disposed on the second conductive layer in the display area and connected to the transistor; and
a wiring pad disposed on the substrate in the pad area,
wherein the wiring pad comprises a first pad electrode disposed in the first conductive layer and a second pad electrode disposed in the second conductive layer.

28. The display device of claim 27, wherein the second pad electrode does not comprise transparent conductive oxide.

29. The display device of claim 27, further comprising a driving component connected to the wiring pad,
wherein the second pad electrode comprises a sub-pad layer directly contacting the driving component and comprising metal.
